# EUROPÄISCHE PATENTSCHRIFT

(11) **EP 3 280 127 B1**
(45) Veröffentlichungstag und Bekanntmachung des Hinweises auf die Patenterteilung: **22.07.2020**
(21) Anmeldenummer: 16182914.8
(22) Anmeldetag: 05.08.2016
(51) Int. Cl.: H04N 5/225

(54) **KAMERASYSTEM**
CAMERA SYSTEM
SYSTEME DE CAMERA

(43) Veröffentlichungstag der Anmeldung: 07.02.2018
(73) Patentinhaber: Hexagon Technology Center GmbH, 9435 Heerbrugg (CH)
(72) Erfinder: SCHEJA, Jochen, 6845 Hohenems (AT)
(74) Vertreter: Kaminski Harmann

(56) Entgegenhaltungen:
- WO-A1-2005/060240
- WO-A1-2013/081339
- DE-A1-102009 030 124
- US-A1- 2015 109 422
- US-B1- 6 337 736
- JAMIESON T H ED - DRIGGERS RONALD G: "THERMAL EFFECTS IN OPTICAL SYSTEMS", OPTICAL ENGINEERING, SOC. OF PHOTO-OPTICAL INSTRUMENTATION ENGINEERS, BELLINGHAM, vol. 20, no. 2, 1 March 1981 (1981-03-01), pages 156-160, XP000955322, ISSN: 0091-3286

## Beschreibung

Die vorliegende Erfindung betrifft ein Kamerasystem für Messanwendungen.

Kamerasysteme, wie sie hier verstanden werden, umfassen: ein Objektiv; einen Objektivträger mit einer Aufnahmeöffnung in welches das Objektiv eingesetzt ist; einen Bildsensor - auch Kamerachip genannt -, wobei Bildsensor und Objektiv so zueinander angeordnet sind bzw. so zueinander angeordnet werden können, dass auf dem Bildsensor ein Bild scharf abbildbar ist; weiter eine Leiterplatte - auch Platine oder PCB genannt - mit welcher der Bildsensor elektrisch leitend kontaktiert ist, so dass die elektrischen Signale, die durch einfallendes Licht im Bildsensor erzeugt werden, auf die Leiterplatte weitergeleitet werden. Die elektrischen Signale können dann von einer Auswerteelektronik verarbeitet werden, welche sich auf der Leiterplatte befindet oder eine mit dieser elektrisch verbundenen Einheit oder mittels sonstiger Signalübertragungseinrichtungen verbundenen Einheit darstellt. Weiter wird der Begriff Objektiv hier in dem Sinne verwendet, dass darunter eine oder mehrere Objektivlinsen oder aber ein Hohlkörper verstanden wird, der in der Regel als Tubus ausgebildet ist, in welchem Objektivlinsen angeordnet sind. Wobei eine Fokussierung durch Verstellen der Linsen bzw. durch Verdrehen oder Verschieben des Tubus mit den darin befindlichen Linsen im Objektivträger erfolgen kann. Als Kamera bzw. Kamerachip können zum Einsatz kommen: CMOS, CCD, Range Imaging Camera (Tiefenmessung mit Time Of Light), Photodiodenarray, Focal Plane Arrays, Thermocam, multispektrale Sensoren. Im optischen Pfad des Kamerasystems, das heisst z.B. im Tubus oder auf dem Kamerachip angebracht, können je nach Anforderung auch spektrale Filter vorgesehen sein. Das Kamerasystem kann ausgelegt sein, um Wellenlängen im sichtbaren Bereich, aber auch im nahen und fernen Infrarotwellenlängenbereich abzubilden.

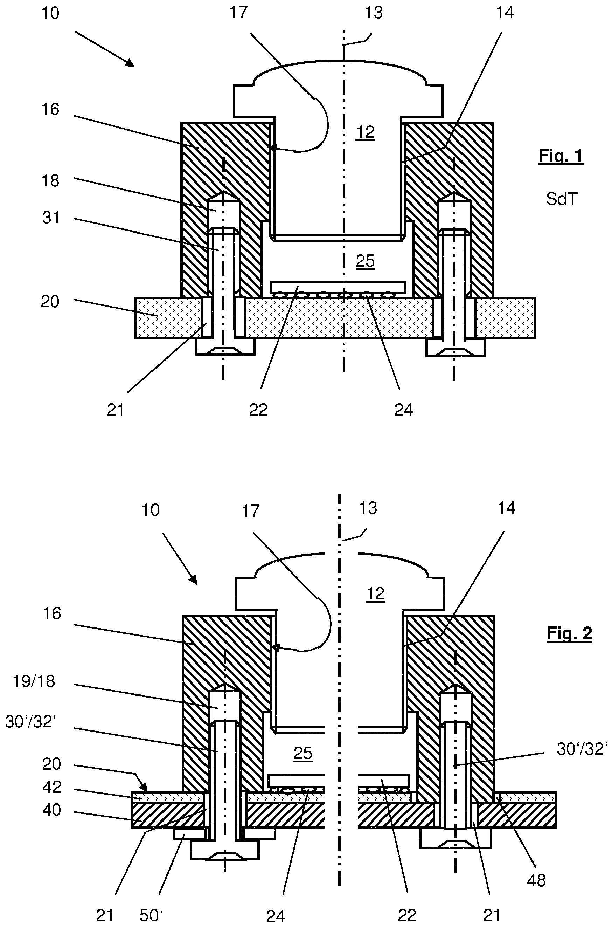

In Fig. 1 ist ein typisches Beispiel für ein Kamerasystem 10 gemäß Stand der Technik gezeigt. Das Objektiv 12 des Kamerasystems 10 ist in dem hier gezeigten Beispiel mit einem Aussengewinde 14 versehen, mit dessen Hilfe das Objektiv 12 in ein Innengewinde einer Aufnahmeöffnung 17 eines Objektivträgers 16 eingeschraubt ist. Die Aufnahmeöffnung 17 ist durchgehend und bildet in Verlängerung der optischen Achse 13 des Objektivs 12 eine Ausnehmung 25, in welcher im montierten Zustand der Bildsensor 22 angeordnet ist. Die Sensorebene des Bildsensors 22 ist dabei möglichst orthogonal zur optischen Achse 13 des Objektivs 12 angeordnet und das Zentrum der Sensorebene möglichst fluchtend zur optischen Achse 13.

Der Bildsensor 22 ist direkt auf einer Leiterplatte 20 fixiert, wobei die Fixierung 24 beispielsweise durch eine Lötverbindung oder Schweissverbindung realisiert ist, so dass der Bildsensor 22 elektrisch leitend mit der Leiterplatte 20 verbunden ist und die elektrischen Signale, die durch einfallendes Licht im Bildsensor 22 erzeugt werden, zur Verarbeitung auf die Leiterplatte 20 weitergeleitet werden können. Als besonders einfach in der Herstellung und als besonders stabile, leitende, direkte Verbindung 24 zwischen Bildsensor 22 und Leiterplatte 20 haben sich Lötverbindungen in Form von Ball Grid Arrays erwiesen.

Die Leiterplatte 20 mit dem auf ihr fixierten Bildsensor 22 wird bei der Montage auf jener, dem Objektiv 12 gegenüberliegenden Seite des Objektivträgers 16 so am Objektivträger 16 befestigt, dass zum einen die durchgehende Öffnung 17 im Objektivträger 16 durch die Leiterplatte 20 verschlossen wird, wodurch sich die Ausnehmung 25 ergibt, und zum anderen der Bildsensor 22 dann, wie oben beschrieben, möglichst senkrecht und mittig zur optischen Achse 13 in der Anusnehmung 25 platziert ist. Hierzu weist der Objektivträger 16 Gewindebohrungen 18 für die Aufnahme von Schrauben 31 auf. Die Leiterplatte 20 weist durchgehende Befestigungsöffnungen 21 auf, die derart angeordnet sind, dass sie dann mit den Gewindebohrungen 18 des Objektivträgers 16 fluchten, wenn der auf der Leiterplatte 20 fixierte Bildsensor 22 mit seiner Sensorebene etwa senkrecht zur optischen Achse 13 und mit seinem Zentrum etwa fluchtend mit der optischen Achse 13 des Objektives 16 ausgerichtet ist. Mit Hilfe der Schrauben 31, die durch die Befestigungsöffnungen 21 der Leiterplatte 20 hindurchgeführt und in die Gewindebohrungen 18 eingedreht werden, wird die Leiterplatte 20 dann in dieser Position lösbar fest mit dem Objektivträger 16 verbunden. Wie aus Fig.1 erkennbar, sind Objektiv 12 und Bildsensor 22 bei nicht ganz fest gezogenen Schrauben 31 relativ zueinander - zumindest bezüglich einer etwa senkrecht zur optischen Achse 13 des Objektivs ausgerichteten Ebene - in lateraler Position justierbar, und durch anziehen der Schrauben dann in dieser justierten Position fixierbar. Alternativ kann anstelle der lateralen Justierbarkeit auch eine definierte laterale Positionsvorgabe realisiert sein, beispielsweise durch mechanische Positionierungshilfen, wie beispielsweise am Objektivträger angeordnete Positionierungsstifte, welche in gegengleich ausgebildete Positionierungsausnehmungen der Leiterplatte eingreifen oder umgekehrt. Eine zusätzliche Fixierung kann beispielsweise auch durch Klebe- oder Lackpunkte sichergestellt sein.

Zum Fokussieren kann in dem hier gezeigten Beispiel die Distanz zwischen Objektiv 12 und Bildsensor 22 eingestellt werden, indem zum Beispiel das Objektiv mit seinem Objektivgewinde 14 tiefer in die Aufnahmeöffnung 17 des Objektivträgers 16 eingeschraubt bzw. aus dieser weiter herausgedreht wird. Auf diese Weise können der Bildsensor 22 und das Objektiv 12 entlang der optischen Achse so zueinander angeordnet werden, dass ein über das Objektiv 12 auf den Bildsensor 22 projiziertes Bild scharf auf dem Bildsensor 22 abgebildet wird.

Kamerasysteme der beschriebenen Art sind oft Bestandteil von höherwertigen Photokameras und weisen dann in der Regel auch einen variablen Fokus auf. In einer einfachen Ausführung eines solchen Kamerasystems sorgt eine Fokussiereinrichtung für eine Fokussierung. Dabei wird das Objektivgewinde motorgetrieben betätigt, was es ermöglicht, den Abstand zwischen Bildsensor und Objektiv entsprechend wie oben beschrieben durch Verdrehen des Objektivs im Objektivträger variabel einzustellen, so dass in einem weiten Bereich ein scharfes Bild auf dem Bildsensor erzeugt werden kann. Die Anforderungen an Kamerasysteme, die in solchen Photokameras verwendet werden, bezüglich Kalibrierbarkeit beziehungsweise bezüglich Genauigkeiten oder tolerierbaren Fehlern, die z.B. auch aus Erschütterungen oder Temperaturschwankungen resultieren können, können mit den heute zur Verfügung stehenden Konstruktionen und technischen Bauteilen in der Regel gut erfüllt werden. Wenn es jedoch um höchste Präzision der Bilderfassung geht, wirken solche Fokussiereinrichtungen aufgrund ihrer vielen gegeneinander bewegbaren Bauteile allerdings oft als Fehlerquellen.

Als Bestandteil von präzisen Messgeräten erfüllen oben genannte Kamerasysteme also häufig nicht die vorgegebenen Anforderungen. Selbst in Messgeräten, in denen bei dem Kamerasystem auf eine Fokussiereinrichtung - und damit auf eine der Fehlerquellen (s.o.) - verzichtet werden kann (z.B. weil die Distanzvarianz gering ist, welche durch das Kamerasystem erfassbar sein muss) werden mit solchen Kamerasystemen häufig Fehler beobachtet, die vor allem quantitativ oft schwer oder gar nicht vorhersagbar sind. Neben plötzlich auftretenden Fehlern z.B. nach Erschütterungen, Stössen oder plötzlichen Temperaturschwankungen, sind dies unter anderem auch Messwertdrift und/oder Hystereseeffekte. Mangels Vorhersagbarkeit ist ein Ausgleich solcher Fehler mittels Software aber auch eine entsprechend Kalibrierung oft schwer oder gar nicht möglich, bzw. muss eine Kalibrierung sehr häufig durchgeführt werden.

Auch wenn, wie oben beschrieben, eine Fokussiereinrichtung nicht vorgesehen ist, bleibt die Verbindung zwischen Objektiv und Objektivträger in vielen Fällen dennoch als Fehlerquelle bestehen, da, wie oben erläutert, die Verbindung zwischen dem Objektiv und dem Bildsensor auf der Leiterplatte im Allgemeinen in Form einer über den Objektivträger realisierten Schraubverbindung ausgebildet ist.

Eine Kamera ebenfalls mit einem auf einer Leiterplatte aufgeschraubten Objektivträger zeigt die WO2005/060240A1. Die Kamera ist zur Verwendung in einem Automobil gedacht und weist ein tubusartiges Objektiv mit mindestens einer Linse auf. Sie weist ferner auf der Leiterplatte einen Bildsensor auf, der einem in den Objektivträger eingesetzten Objektiv gegenüberliegt. Nicht immer gelingt es, den Bildsensors ohne leichte Verkippung (bis 2°) auf der Leiterplatte zu montieren, was dann dazu führt, dass eine fokussierte Bildprojektion nicht mehr über den gesamten flachen Bildsensor möglich ist. Dieses Problem wird dadurch gelöst, dass der Objektivträger eine zylindrische Aufnahmeöffnung für das Objektiv besitzt, das Objektiv aber ein kugelsegmentartiges Anschlussstück aufweist, das eingepasst in die Aufnahmeöffnung das Objektiv im Objektivträger hält und das Objektiv in seiner Winkelstellung gegenüber dem Objektivträger und somit gegenüber dem Bildsensor verstellbar macht. Das Objektiv ist aus Kostengründen vorzugsweise ein handelsübliches Objektiv, an dem das kugelsegmentartiges Anschlussstück entweder angespritzt oder angeklebt ist. WO2013/081339 offenbart ein Kameramodul mit einem Objektivträger und einem Objektiv, die miteinander verbunden sind, wobei das Objektiv nach entsprechender Fokussierung des Brennpunktes auf dem Bildsensor, in den Objektivträger eingeklebt wird.

Eine weiter Fehlerquelle bei Präzisionsanwendungen können unterschiedliche thermische Ausdehnungskoeffizienten innerhalb des Objektivs, also der Objektivlinsen einerseits und des die Linsen tragenden Tubus andererseits aber auch zwischen Objektiv und Objektivträger sein. Die Objektivlinsen sind in der Regel aus Glas gefertigt und weisen daher einen verhältnismässig kleinen thermischen Ausdehnungskoeffizienten a_{G1} im Bereich von a_{G1} = 0.5^{∗}10-6 K⁻¹ bis 9^{∗}10-6 K⁻¹ auf. Tubus bzw. Objektivträger sind dagegen häufig aus Aluminium bzw. einer Aluminiumlegierung gefertigt, so dass deren thermischer Ausdehnungskoeffizient a_{Ob} im Bereich von a_{Ob} = 22^{∗}10⁻⁶ K⁻¹ bis 24^{∗}10-6 K⁻¹ liegt.

DE102009030124A1 offenbart eine Optik, wie sie in Verbindung mit lithographischen Prozessen bei der Herstellung von Wafern verwendet wird, was eine hohe Präzision erfordert. Thermische Driftphänomene stehen einer solchen Präzision entgegen. Die hier offenbarte Optik weist daher Linsen und Linsenträger auf, die aus Materialien mit nahezu gleichen Wärmeausdehnungskoeffizienten hergestellt sind. Zum Beispiel sind Linsen und Linsenträger aus Silikatglas oder Kalciumfluorid hergestellt; oder die Linsen bestehen aus Silikatglas bzw. Kalziumfluorid, aber die Linsenträger bestehen aus Invar 36 oder NiMn20 oder einer anderen geeigneten Metalllegierung mit einem ähnlichen Wärmeausdehnungskoeffizienten. Die Fixierung der Linsen im Linsenträger erfolgt durch Schmelzklebung oder optische Kontaktierung.

US6337736B1 bezieht sich auf einen Entfernungsmesser, der auf dem Triangulationsverfahren basiert. Zwei im Abstand der Grundlinienlänge zueinander auf einer Leiterplatte montierte CCD-Chips sind jeweils von einem Gehäuse umschlossen. Auf jener der Leiterplatte und dem CCD-Chip gegenüberliegenden Seite des Gehäuses ist jeweils eine Linse derart angeordnet, dass der CCD-Chip in der Brennebene seiner Linse liegt. Die in den CCD-Chips erzeugte Wärme führt zu thermischen Spannungen, die zu Messfehlern führen. Um diese Fehler zu vermeiden bzw. zu kompensieren, sind die konstituierenden Element, wie Linsen und Gehäuse sowie CCD-Trägerleiterplatte aus dem gleichen Kunststoffmaterial hergestellt. Ausserdem sind Temperatursensoren zwischen den beiden Linsen und weitere Temperatursensoren zwischen den CCD-Chips auf der CCD-Trägerplatte angeordnet, so dass thermische Veränderungen der Grundlinienlänge bei der Triangulationskalkulation berücksichtigt werden können.

US2015/109422A1 bezieht sich auch auf ein Stereokamerasystem eines Entfernungsmessers, mit prinzipiell gleichem Aufbau wie US6337736B1. Um die beiden im Abstand der Grundlinienlänge voneinander auf einer Leiterplatte montierten optischen Einheiten trotz thermischer oder mechanischer Spannung in präziser Ausrichtung zu halten, hat in diesem Beispiel die gemeinsame Leiterplatte eine Steifigkeit von mindestens dem Dreifachen der Steifigkeit einer FR4-Leiterplatte ähnlicher Größe oder eine Dicke von mindestens 3 mm. Zu diesem Zweck besteht die gemeinsame Leiterplatte aus faserverstärktem Harz oder ist eine mehrschichtige Leiterplatte, wobei eine Versteifungsschicht im Wesentlichen den gleichen Wärmeausdehnungskoeffizienten wie andere Schichten der Leiterplatte aufweist. Schlussendlich hat aber die mehrschichtige Leiterplatte einen höheren Grad an Steifigkeit als eine FR4-Standardleiterplatte, wobei die Versteifungsschicht aber aus einem typischen Leiterplattenmaterial ist.

Für präzise Messungen unter Verwendung des Kamerasystems kann auch die Verbindung bzw. Befestigung des Bildsensors auf der Leiterplatte eine weitere Fehlerquelle darstellen. Für diese Befestigung sind, wie bereits oben erwähnt, verschiedenste Möglichkeiten bekannt, wie Löten und Schweissen und eine Ausführung des Bildsensors als SMD-Chip mit Anschluss-Pins für THT Verbindungstechnik. Die von den bekannten Verbindungen mechanisch wohl steifste Möglichkeit für eine direkte Verbindung von Bildsensor und Leiterplatte ist die Verbindung mittels Ball Grid Array (BGA). Beim Ball Grid Array werden in einem Raster angeordnete Lötperlen durch Reflow-Löten aufgeschmolzen, das heisst durch Erwärmen in einem Lötofen, so dass anschliessend das aufgeschmolzene und wieder erstarrte Lötmaterial Kontakt-Pads des Bildsensors mit Kontakt-Pads der Leiterplatte fest verbindet.

Eine weitere Fehlerquelle, wenn solche Kamerasysteme in Messgeräten für hochgenaue Messungen eingesetzt werden, bilden auch die üblicherweise verwendeten Leiterplatten, die in der Regel aus FR4 mit Kupferleiterbahnen gefertigt sind. FR4 ist ein Verbundwerkstoff aus schwerentflammbaren und flammhemmendem Epoxidharz und Glasfasergewebe, welches anisotrope, d.h. richtungsabhängige thermische Ausdehnungskoeffizienten von typischer Weise aₓ = 14^{∗}10⁻⁶ K⁻¹; a_{y} = 18^{∗}10⁻⁶ K⁻¹; a_{z} = 60^{∗}10⁻⁶ K⁻¹ aufweist (die Indizes x, y, z stehen für die kartesischen Richtungen). Steckplätze für Pin-bewährte Kamerachips oder Positionierhilfen für direkt auflötbare SMD-Kamerachips sowie auch die durchgehenden Befestigungsöffnungen, über welche die Leiterplattte - üblicherweise mit Hilfe von Schrauben - mit dem Objektivträger und dem darin befindliche Objektiv verbunden werden, können in der Leiterplatte nicht mit einer für die Anforderungen solcher Messgeräte ausreichender Genauigkeit gefertigt werden. Deswegen können die Position des Kamerachips auf der Leiterplatte, die Position der Leiterplatte gegenüber dem Objektivträger und somit auch die Position des Kamerachips gegenüber dem Objektiv nicht hinreichend genau festgelegt werden bzw. ändern sich deren Positionen zueinander z.B. bei Erschütterungen oder Temperaturschwankungen, etc..

In CN202004864U wird daher eine Positionierhilfe in Form einer Aluminiumschablone vorgeschlagen, die auch nach der Positionierung im Kamerasystem verbleibt. Die Aluminiumschablone weist einen genau definierten Steckplatz für den Kamerachip auf und wird zusammen mit dem Kamerachip auf der Leiterplatte aufgeschweisst. Die Aluminiumschablone ist nur wenig grösser als der Kamerachip und weist seitlich von dem Kamerachip Durchgangsöffnungen auf, die in aufgeschweisstem Zustand mit den Befestigungsöffnungen der Leiterplatte fluchten. Da nach Aussage dieses Dokuments die Aluminiumschablone mit Ihrem Steckplatz für den Kamerachip und ihren Durchgangsöffnungen sehr viel genauer gearbeitet werden kann als die Leiterplatte, kann mit Hilfe der Aluminiumschablone bei der Montage eine wesentlich genauere Positionierung der einzelnen Bauteile zueinander erreicht werden.

Bei anderen, bekannten Kamerasystemen sollen die Fehler, welche sich insbesondere durch Fertigungstoleranzen der Befestigungsöffnungen der Leiterplatte ergeben, durch eine glasbasierte Verbindungskonstruktion vermieden werden. Dabei wird eine Rückseite des Bildsensors in üblicher Weise mit einer Leiterplatte verbunden, die Frontfläche des Bildsensors wird hingegen auf ein Trägerglas geklebt. Das Trägerglas ragt über den Rand des Bildsensors hinaus. Dieser überstehende Rand des Trägerglases ist mit seiner dem Bildsensor abgewandten Seite - beispielsweise mittels einer temperaturstabilen Klebung - fest mit dem Objektivträger verbunden, in welchen das Objektiv eingeschraubt ist. Auf diese Weise ist die Leiterplatte nur über den Bildsensor mit dem Objektivträger verbunden. Alle Fehlerquellen, die möglicherweise bedingt sind durch die Verbindung des Bildsensors via Leiterplatte und Schrauben mit dem Objektivträger, sind mit dieser Konstruktion ausgeräumt. Dagegen ist es anscheinend relativ einfach möglich mit hoher Präzision in die Glasplatte Positionierhilfen für die Befestigung des Bildsensors einerseits und die Befestigung der Glasplatte an dem Objektivträger andererseits einzubringen. Allerdings ist diese Konstruktion sehr aufwändig in der Herstellung und die Leiterplatte ist nur mittels der herkömmlichen Lötstellen-Verbindung zum Bildsensor mit dem Kamerasystem verbunden, so dass im Falle von Erschütterungen oder Stössen die Stabilität der Verbindung Bildsensor-Leiteplatte allein durch die Lötstellen gewährleistet werden muss.

Die Aufgabe der vorliegenden Erfindung ist es, ein Kamerasystem zur Verfügung zu stellen, dass einfach und kostengünstig in der Herstellung ist und trotzdem wenigstens einige der oben genannten, insbesondere für eine Verwendung in Präzisions-Messgeräten gravierenden Nachteile, wie Messwertdrift, Hystereseeffekte und schwer vorhersagbare Fehler, verringert oder vermeidet.

Diese Aufgaben werden zumindest teilweise durch ein Kamerasystem gemäss Anspruch 1 bzw. durch Weiterbildungen, wie sie in den abhängigen Ansprüchen wiedergegeben sind, gelöst.

Ein solches Kamerasystem umfasst ein Objektiv mit einem Tubus und mit mindestens einer im Tubus angeordneten Objektivlinse, einen das Objektiv tragenden Objektivträger, einen Bildsensor und eine Leiterplatte. Die Leiterplatte und der Bildsensor sind elektrisch leitend miteinander verbunden so dass die elektronischen Signale die durch das Licht, welches durch das Objektiv auf den Bildsensor fällt zur Verarbeitung an die Schaltkreise der Leiterplatte weitergeleitet werden können. Der Bildsensor und das Objektiv sind so zueinander anordenbar, dass ein über das Objektiv auf den Bildsensor projiziertes Bild scharf auf dem Bildsensor abbildbar ist. Der Objektivträger und die Leiterplatte sind dabei aus Materialien gefertigt, deren thermischer Ausdehnungskoeffizient um weniger als 30% voneinander abweicht.

In einer ersten Ausführungsform ist die Leiterplatte als FR4-Board gefertigt, welches einen thermischen Ausdehnungskoeffizienten in der x-y-Ebene im Bereich von a_{L}=12^{∗}10⁻⁶/K bis 14^{∗}10⁻⁶/K besitzt und der Objektivträger ist aus einem rostfreien Stahl hergestellt, dessen thermischer Ausdehnungskoeffizient ebenfalls im Bereich von a_{O}=10^{∗}10⁻⁶/K bis 16^{∗}10⁻⁶/K liegt, wie beispielsweise Chromstahl 1.4034 (X46Cr13) mit a_{O}=10.5^{∗}10⁻⁶/K bei 20°C-100°C.

In einer anderen Ausführungsform umfasst die Leiterplatte einen Leiterplattenträger auf dem mindestens eine Schaltkreisschicht angeordnet ist. Die Schaltkreisschicht umfasst im Wesentlichen eine Schicht aus elektrisch isolierendem Material, wie PA oder FR4, und die vorbestimmten, vorzugsweise aus Kupfer gearbeiteten Schaltkreise der Leiterplatte. Der Leiterplattenträger ist aus einem Material gefertigt, dessen thermischer Ausdehnungskoeffizient a_{L} um höchstens 30%, besser um höchstens 25%, noch besser um höchstens 20% vom thermischen Ausdehnungskoeffizienten a_{O} des Materials abweicht, aus dem der Objektivträger gefertigt ist. Dabei versteht es sich, dass sich die thermischen Ausdehnungskoeffizienten a_{L}, a_{O} auf einen Temperaturbereich von etwa -5°C bis +90°C beziehen. Besonders bevorzugt sind dabei Materialien für den Leiterplattenträger die zudem eine gute Leitfähigkeit aufweisen, wie beispielsweise Kupfer oder Aluminium und deren Legierungen.

Unterscheiden sich die thermischen Ausdehnungskoeffizienten des Leiterplattenträgers a_{L} und des Objektivträgers a_{O} höchstens 30%, besser um höchstens 20% bis 25% von einander, können thermische Spannungen zwischen Leiterplatte und Objektivträger vermieden werden, die zu Fehlern, insbesondere zu Messwertdrift führen können. Wenn Objektivträger und Leiterplatte, wie aus dem Stand der Technik bekannt, mittels Schraubverbindung miteinander verbunden sind, so kann hierdurch auch einer Lockerung der Schraubverbindung entgegengewirkt werden.

Besser ist es freilich, wenn der Unterschied Δa zwischen den thermischen Ausdehnungskoeffizienten a_{L} (Leiterplatte) und a_{O} (Objektivträger) kleiner als 10% ist oder überhaupt möglichst klein. Besonders vorteilhaft ist es, wenn die thermischen Ausdehnungskoeffizienten a_{L} (Leiterplatte) und a_{O} (Objektivträger) gleich sind (Δa= 0), was natürlich am einfachsten durch die Verwendung des gleichen Materials für einen Leiterplattenträger und den Objektivträger möglich ist. Anders ausgedrückt: der Unterschied Δa zwischen dem thermischen Ausdehnungskoeffizienten a_{L} des Leiterplattenträgers und a_{O} des Objektivträgers sollte im Bereich von 0 ≤ Δa ≤ 30% liegen.

Besonders vorteilhaft ist es, insbesondere für hochstabile Kamerasysteme, wenn Tubus, Objektivträger und Leiterplattenträger jeweils aus einem Material gefertigt sind, dessen thermischer Ausdehnungskoeffizient um höchstens 30%, besser um höchstens 25% vom thermischen Ausdehnungskoeffizienten der wenigstens einen Objektivlinse abweicht. Ist die wenigstens eine Objektivlinse beispielsweise aus BK7 mit einem thermischen Ausdehnungskoeffizienten von etwa a=7^{∗}10⁻⁶/K, können Tubus, Objektivträger und Leiterplattenträger beispielsweise aus Titan gefertigt sein, denn Titan hat einen thermischen Ausdehnungskoeffizienten von etwa a=8^{∗}10⁻⁶/K bis 9^{∗}10⁻⁶/K.

In noch einer anderen Ausführungsform ist der Fokus auf eine thermische Anpassung von Kamerachip(=Bildsensor) und Leiterplattenträger gelegt. Der Leiterplattenträger ist in diesem Beispiel aus einem Material gefertigt, dessen thermischer Ausdehnungskoeffizient um höchstens 25% bis 30% vom thermischen Ausdehnungskoeffizienten des Bildsensors/Kamerachips abweicht. Der Kamerachip ist in der Regel aus Silizium gefertigt, das einen thermischen Ausdehnungskoeffizienten von a_{B}=2^{∗}10⁻⁶/K bis 3^{∗}10⁻⁶/K hat. Die Wahl eines geeigneten Materials für den Leiterplattenträger wie beispielsweise Invar mit einem thermischen Ausdehnungskoeffizienten von a_{L}=1^{∗}10⁻⁶/K bis 2^{∗}10⁻⁶/K, genügt auch höchsten Anforderungen an die thermische Stabilität. Andere mögliche Materialien für den Leiterplattenträger sind in diesem Fall Keramiken oder Glaskeramiken. Bei diesen kann der Ausdehnungskoeffizient durch die Auswahl der Mischungskomponenten in der Regel individuell eingestellt werden.

Die genannten Bauteile des Kamerasystems, nämlich Objektivträger; Objektivlinse(n) und Tubus (zusammengefasst auch als Objektiv bezeichnet); Leiterplattenträger und Schaltkreisschicht(en) (zusammengefasst auch als Leiterplatte bezeichnet), können in montiertem Zustand entweder sein mittels unten näher beschriebenen Verbindungsarten miteinander verbunden oder sie können nur durch eine thermisch stabile Klebung miteinander verbunden sein oder aber zusätzlich zu den unten näher beschriebenen Verbindungsarten auch noch miteinander verklebt sein. Hierfür weist der verwendete Klebstoff entweder einen thermischen Ausdehnungskoeffizienten auf, der höchstens um 25% bis 30% von demjenigen Ausdehnungskoeffizienten der Materialien abweicht, aus dem die zu verbindenden Bauteile gefertigt sind, und/oder der Klebstoff ist so gewählt, dass er die thermischen Spannungen, die aufgrund unterschiedlicher thermischer Ausdehnungskoeffizienten der zu verbindenden Bauteile entstehen, aufnehmen kann, so dass sich die Bauteile trotz der unterschiedlichen Ausdehnung nicht oder nur minimal zueinander bewegen. Ein solcher Klebstoff weist beispielsweise einen thermischen Ausdehnungskoeffizienten im Bereich von a_{K}=22^{∗}10⁻⁶/K bis 25^{∗}10⁻⁶/K auf und vorzugsweise eine Härte im Bereich von 75 bis 90 Shore D.

Vorteilhaft ist das Material aus dem der Objektivträger bzw. der Leiterplattenträger hergestellt ist, ein Material aus folgender Gruppe von Materialien: Cu-Legierungen, wie Bronze bzw. Messing; rostfreier Stahl, insbesondere niedriglegierter rostfreier Stahl; Magnesiumlegierung; Aluminium, Aluminiumlegierungen, insbesondere Aluminiumknetlegierungen, wie z.B. EN AW-6061; alternativ können auch aufwändiger herzustellende Leiterplattenträger aus Glas, Glaskeramik oder Keramik eingesetzt werden; wobei die Materialien so gewählt sind, dass für die Abweichung Δa_{L} des thermischen Ausdehnungskoeffizienten a_{L} des Materials des Leiterplattenträgers vom thermischen Ausdehnungskoeffizienten a_{O} des Materials des Objektivträgers gilt: 0% ≤ Δa_{L} ≤ 30%, besser 0% ≤ Δa_{L} ≤ 20% oder noch besser 0% ≤ Δa_{L} ≤ 10%.

Ist der Leiterplattenträger aus einem Metall gefertigt, hat dies den zusätzlichen Effekt, dass Wärme gut abgeführt wird, was ebenfalls Wärmespannungen und damit thermisch induzierten Fehlern entgegenwirkt.

Ist das Material, das für Leiterplattenträger bzw. Objektivträger gewählt wird, zudem gut bearbeitbar, können auch die Fertigungstoleranzen klein gehalten werden, z.B. Passbohrungen mit einem Toleranzfeld kleiner 10 Micrometer, was ebenfalls Messfehlern vorbeugt und auch einer Lockerung von Schraubverbindungen entgegenwirkt. Gut bearbeitbar heisst hier insbesondere, dass das Material gut spanend bzw. spanabhebend bearbeitbar ist, also z.B. Fliessspäne bildet bzw. bei der spanabhebenden Bearbeitung (wie Drehen, Fräsen, Bohren, Schleifen), eine gute Oberflächenqualität erzielbar ist bzw. das Material eine hohe Schneidhaltigkeit zeigt (Schneidhaltigkeit, siehe beispielsweise DIN 6583).

Sind der Objektivträger und die Leiterplatte mittels Verbindungselementen (Schrauben, Klammern, Bolzen) miteinander verbunden, ist es ebenfalls vorteilhaft, wenn die Verbindungselemente aus einem Material hergestellt sind, dessen thermischer Ausdehnungskoeffizient aᵥ in Bezug auf den Ausdehnungskoeffizienten des Objektivträgers im Bereich von 0 ≤ Δa ≤ 30%, besser 0 ≤ Δa ≤ 20% noch besser 0 ≤ Δa ≤ 10% liegt.

Sind die Verbindungselemente Klammern, Nieten, Schrauben, Gewindebolzen, Muttern usw., und sind diese ausgebildet, wie dies im vorgängigen Absatz beschrieben ist, ist es auch vorteilhaft, wenn Unterlegscheiben und/oder Schraubensicherungselemente, wie Federringe, Schnorrscheiben, etc., aus Material gefertigt sind, dessen thermischer Ausdehnungskoeffizienten in Bezug auf den Ausdehnungskoeffizienten des Objektivträgers im Bereich von 0 ≤ Δa ≤ 30% liegt.

Wie aus dem Stand der Technik bekannt, kann der Bildsensor aufgeschweisst, aufgelötet oder mittels Ball Grid Array auf der Leiterplatte bzw. ihrer Schaltkreisschicht aufgelötet sein. Neben einer Realisierung als Lötverbindung oder Schweissverbindung sind aber auch alle anderen Arten leitender Verbindungen ebenso denkbar, wie beispielsweise elektrisch leitender Klebstoff, Leitgummi, Feder-Kontakte, Flexleiterplatten, Bond-Drähte, oder Steckverbindungen (THT), etc. oder Kombinationen davon.

In einer besonders vorteilhaften Variante des Kamerasystems ist der Bildsensor entlang seiner Ränder mittels elektrisch leitender Verbindung mit der Schaltkreisschicht der Leiterplatte verbunden, wobei die Schaltkreisschicht in einem Bereich unter dem Bildsensor ein Loch besitzt, und dieses Loch umgeben ist von der/den randnahen, leitenden Verbindung(en). Der Bildsensor ist durch dieses Loch hindurch mittels eines Stützelements fest mit dem Leiterplattenträger verbunden. Auf diese Weise lässt sich eine stabilere Positionierung des Bildsensors gegenüber der Leiterplatte und via die Leiterplatte mit dem Objektivträger und damit gegenüber dem Objektiv erreichen, stabiler als wenn der Bildsensor nur mittels Lötverbindung oder ähnlichem mit der Schaltkreisschicht der Leiterplatte verbunden wäre.

Ist das Stützelement aus einem Material gefertigt, dessen thermischer Ausdehnungskoeffizienten in Bezug auf den Ausdehnungskoeffizienten des Leiterplattenträgers im Bereich von 0 ≤ Δa ≤ 30%, besser 0 ≤ Δa ≤ 20% bis 25% liegt, werden zudem thermische Effekte minimiert. Noch weiter lassen sich thermische Effekte minimieren, wenn das Stützelement aus dem gleichen Material gefertigt ist wie der Leiterplattenträger und insbesondere, wenn es einstückig mit dem Leiterplattenträger ausgebildet ist.

Sind zudem der Leiterplatteträger und das Stützelement aus einem Material, das nahezu oder tatsächlich den gleichen thermischen Ausdehnungskoeffizienten hat wie der Objektivträger, aber jedenfalls mit einem Unterschied Δa im Bereich von 0 ≤ Δa ≤ 30%, ist es möglich, thermisch induzierte Messfehler nahezu ganz zu eliminieren.

Ist der Bildsensor mittels Stützelement mit dem Leiterplattenträger verbunden, wie dies oben beschrieben ist, so ist die Verbindung zwischen Bildsensor und Stützelement vorteilhafter Weise durch Löten, Schweissen, Zementieren oder eine thermisch stabile Klebung realisiert.

Besonders vorteilhaft ist es, den Bildsensor schwimmend auf dem Leiterplattenträger zu lagern, weil dies gegen thermische und mechanische Spannungen ausgleichend wirkt. Bei der hier als "schwimmende Lagerung" bezeichneten Verbindung zwischen zwei Bauteilen, und insbesondere zwischen Bildsensor und Leiterplattenträger, ist der Bildsensor maximal mittels dreier harter Klebepunkte, besser nur mittels eines harten Klebepunkts fest mit dem Leiterplattenträger verbunden. Optional kann er ausserdem noch mittels weiterer, weicher Klebepunkte mit dem Leiterplattenträger verbunden sein. Wie viele harte Klebepunkte und ob und wie viele weiche Klebepunkte verwendet werden bei einer solchen schwimmenden Lagerung, ist abhängig von der Grösse des Bildsensors und den Materialien, aus denen der Bildsensor und der Leiterplattenträger gefertigt ist. Unter harten Klebepunkten werden dabei Klebepunkte verstanden, bei denen die Klebstelle im ausgehärteten Zustand zumindest im Vergleich mit den weichen Klebepunkten eine höhere Schubsteifigkeit besitzt.

Die Eigenschaften der hier als "schwimmende Lagerung" bezeichneten Verbindung zweier Bauteile werden bestimmt durch die Wahl des Klebstoffes bzw. der Klebstoffe, aber auch durch die Geometrie der Klebung, z.B. durch die Klebespaltdicke, die Anzahl und Verteilung der Klebestellen und sowie das Verhältnis von verklebter und unverklebter Fläche.

Je nachdem welche Aufgaben die Leiterplatte erfüllen soll, kann es sinnvoll sein, eine Leiterplatte vorzusehen, die entweder nur auf einer Seite des Leiterplattenträgers eine Schaltkreisschicht aufweist, oder eine Leiterplatte die sowohl auf der dem Bildsensor zugewandten Seite des Leiterplattenträgers eine Schaltkreisschicht aufweist als auch auf der dem Bildsensor abgewandten Seite. Auch mehrlagige Leiterplatten mit einem oder mehreren Leiterplattenträgern und entsprechend mehreren entweder unmittelbar übereinander angeordneten Schaltkreisschichten oder wenigstens zum Teil durch Leiterplattenträger voneinander getrennten Schaltkreisschichten sind denkbar.

Vorteilhaft sind Leiterplatten mit symmetrischem Aufbau, das heisst mit einem Leiterplattenträger z.B. aus Aluminium bzw. einer Aluminiumlegierung oder einem anderen Metall oder auch aus Keramik, Glas, Glaskeramik, und einer gleichen Anzahl von übereinander angeordneten Schaltkreisschichten auf jeder der beiden Seiten des Leiterplattenträgers, wobei die Schaltkreisschichten Schaltkreise umfassen, die vorzugsweise aus Kupfer mit einer Dicke von 0.035mm bis 0.02mm gefertigt sind und ein Dielektrikum mit einer relativ geringen Dicke von beispielsweise 0.05mm bis 0.8mm, insbesondere von 0.3mm. Das Dielektrikum weist vorzugsweise nur eine geringe oder gar keiner Faserverstärkung auf und ist beispielsweise ein PA oder FR4. Pro Seite des Leiterplattenträgers können beispielsweise 5 bis 8 oder auch noch mehr solcher Schaltkreisschichten übereinander vorgesehen sein. Die Schaltkreisschichten werden vollflächig verpresst und verklebt. Durch den daraus resultierenden schubsteifen Verbund und die geringere Steifigkeit der Schaltkreisschichten gegenüber dem Leiterplattenträger folgen die Schaltkreisschichten im Wesentlichen der Dehnung des Leiterplattenträgers.

In einer weiteren vorteilhaften Ausführungsform ist der Objektivträger im Bereich der Befestigungsausnehmungen für die Aufnahme von Verbindungselementen mit Positionierungsflanschen versehen, die in Richtung der zu montierenden Leiterplatte abstehen und vorzugsweise die Befestigungsausnehmungen fluchtend verlängern. Die Befestigungsöffnungen in der Leiterplatte sind so ausgestaltet, dass sie die Positionierflansche des Objektivträgers aufnehmen, und zwar vorteilhaft mit keinem oder geringem Spiel; wie beispielsweise mit einer Spielpassung H7/g6, oder mittels einer Presspassung. Dabei können auch unterschiedliche Geometrien in Teilpresspassungen vorgesehen sein, wie beispielsweise quadratischer Positionierflansch in kreisförmige Befestigungsöffnung mit entsprechend aufeinander abgestimmten Durchmesser bzw. Kantenlänge u.ä.. Alternativ oder zusätzlich können die Positionierflansche des Objektivträgers in die Befestigungsöffnungen der Leiterplatte eingeklebt sein. Auf diese Weise wird die Verbindung zwischen Leiterplatte und insbesondere dem Leiterplattenträger und dem Objektivträger weiter verbessert.

In einer weiteren Ausführungsform weisen Objektivträger und Leiterplattenträger jeweils Gewinde auf, mittels derer sie miteinander verschraubbar sind. Durch die direkte Verschraubbarkeit dieser beiden Elemente miteinander, statt über Schrauben und Muttern lassen sich weitere Fehlerquellen ausräumen.

In einer weiteren Ausführungsform sind Objektivträger und der Leiterplattenträger miteinander verschweisst, verlötet oder verklebt. Die Elemente können dann zwar nicht mehr zerstörungsfrei voneinander getrennt werden, die Stabilität dieser Verbindung, insbesondere auch ihre thermische Stabilität, ist aber hervorragend.

Noch bessere Resultate erhält man, wenn Objektivträger und Leiterplattenträger einstückig ausgebildet sind.

Ebenfalls fehlerreduzierend wirkt es sich aus, wenn das Objektiv in die Aufnahmeöffnung des Objektivträgers eingeklebt ist.

Für die verschiedenen oben vorgeschlagenen Klebungen eignen sich beispielsweise formstabile, Zweikomponenten-Epoxidkleber mit guter Wärmeleitfähigkeit im Bereich von 1.2 W/mK bis 1.6 W/mK und einem thermischen Ausdehnungskoeffizienten im Bereich von 20^{∗}10-6 K⁻¹ bis 27^{∗}10-6 K⁻¹. Je nach gewünschtem Einsatzort ist es Vorteilhaft, einen in ausgehärtetem Zustand eher weicheren oder härteren solchen Zweikomponentenkleber zu verwenden. Für eine Klebeverbindung zwischen Objektivträger und Leiterplatte bzw. zwischen Tubus des Objektives und Objektivträger sind solche Klebstoffe mit Härten im Bereich von 75 bis 95 Shore D, besser noch im Bereich von 80 bis 85 Shore D verwendbar.

Ein erfindungsgemässes Kamerasystem wird nachfolgend anhand von in den Figuren dargestellten Ausführungsbeispielen näher beschrieben. Die Figuren sind nicht massstabsgetreu und zur Verdeutlichung können einzelne Elemente überdimensioniert dargestellt sein. In den verschiedenen Figuren werden gleiche Bauteile mit den gleichen Bezugszeichen gekennzeichnet. Die Erläuterungen erfolgen nur beispielhaft und haben keine beschränkende Wirkung. Die Figuren zeigen rein schematisch:
- Fig.1: Im Schnitt ein Kamerasystem gemäß dem Stand der Technik;
- Fig.2: im Schnitt eine erste Ausführungsform eines erfindungsgemässen Kamerasystems;
- Fig.3: ebenfalls im Schnitt eine Variante der in Fig. 2 dargestellten Ausführungsform des Kamerasystems;
- Fig.4: eine weitere Variante der in Fig. 2 dargestellten Ausführungsform des Kamerasystems;
- Fig.5a, 5b: im Schnitt Beispiele für einen Leiterplattenträger mit einer auf diesem schwimmend gelagerten Schaltkreisschicht bzw. einem schwimmend gelagerten Bildsensor;
- Fig. 6a, 6b: im Schnitt Beispiele für einen Leiterplattenträger mit Schaltkreisschichten auf beiden Seiten;
- Fig.7: ebenfalls im Schnitt eine weitere Ausführungsform eines Kamerasystems;
- Fig.8: anhand eines Ausschnitts eines Kamerasystems, wie es in Fig. 2 bis 7 dargestellt ist, eine weitere erfindungsgemässe Massnahme;
- Fig.9: anhand eines Ausschnitts eines Kamerasystems, wie es in einer der Fig. 5 dargestellt ist, noch eine weitere erfindungsgemässe Massnahme;
- Fig.10 bis 12: im Schnitt eine weitere Ausführungsform eines Kamerasystems in drei verschiedenen Varianten;
- Fig.13a, 13b: im Schnitt zwei Varianten einer weiteren Ausführungsform eines Kamerasystems; und
- Fig.14 bis 15: im Schnitt noch eine weitere Ausführungsform eines Kamerasystems in zwei verschiedenen |Varianten|.

In **Fig. 2** ist eine erste Ausführungsform eines erfindungsgemässen Kamerasystems 10 dargestellt. Es umfasst ein Objektiv 12, das mit einem Aussengewinde 14 versehen ist. Das Objektiv 12 umfasst einen Tubus und darin angeordnet mindestens eine Linse, auch Objektivlinse(n) genannt. Die Linse(n) sind aus Glas oder einem anderen optisch transparenten Medium gefertigt, das auf die Anforderungen eines Messgerätes, in welchem das Kamerasystem verwendet werden soll, abgestimmt ist. Weiter umfasst das Kamerasystem 10 einen Objektivträger 16 mit einer Aufnahmeöffnung 17 für die Aufnahme des Objektivs 12, die in diesem Beispiel durchgehend ausgestaltet ist. Die Aufnahmeöffnung 17 ist mit einem Innengewinde versehen, wobei das Innengewinde nicht durchgehend sein muss aber durchgehend sein kann. Das Innengewinde und der Durchmesser der Aufnahmeöffnung 17 im Bereich des Innengewindes sind abgestimmt auf den Aussendurchmesser des Objektivs 12 im Bereich seines Aussengewindes 14, so dass das Objektiv 12 mit Hilfe des Objektivgewindes 14 in den Objektivträger 16 einschraubbar ist. Vielfach kommen hier Feingewinde, speziell mit geringem oder vorzugsweise gar keinem Gewindespiel zum Einsatz. Bei eingeschraubtem Objektiv 12 bildet die durchgehende Aufnahmeöffnung 17 in Richtung der optischen Achse 13 des eingeschraubten Objektives 12 zusammen mit einem Teil des Objektivs 12 eine Ausnehmung 25 im Objektivträger 16, welche von der dem Objektiv 12 gegenüberliegenden Seite zugänglich ist und der Aufnahme des Bildsensors 22 dient. Der Bildsensor 22 ist mittels einer elektrisch leitenden Verbindung 24 mit einer Leiterplatte 20 verbunden, insbesondere mittels einer stabilen Lötverbindung, wie beispielsweise mittels eines Ball Grid Array.

Die Leiterplatte 20 mit dem darauf fixierten Bildsensor 22 wird bei der Montage auf jener, dem Objektiv 12 gegenüberliegenden Seite des Objektivträgers 16 so am Objektivträger 16 befestigt, dass der auf der Leiterplatte 20 befestigte Bildsensor 22 mit seinem Zentrum vorzugsweise fluchtend und mit seiner Sensorebene so weit technisch möglich senkrecht zur optischen Achse 13 ausgerichtet in der Ausnehmung 25 platziert ist. Hierzu weist der Objektivträger 16 in diesem Beispiel Befestigungsausnehmungen 19 auf, die im gezeigten Beispiel als Gewindebohrungen 18 ausgebildet sind. Die Leiterplatte 20 ist mit durchgehenden Befestigungsöffnungen 21 versehen, die derart angeordnet sind, dass sie dann mit den Befestigungsausnehmungen 19 des Objektivträgers 16 fluchten, wenn der auf der Leiterplatte 20 fixierte Bildsensor 22 mit seinem Zentrum fluchtend mit der optischen Achse 13 des Objektives ausgerichtet ist. Mit Hilfe von Verbindungselementen 30' ist die Leiterplatte 20 und mit ihr der Bildsensor 22 in der beschriebenen Position lösbar fest mit dem Objektivträger 16 verbunden. Die Verbindungselemente 30' sind in der hier gezeigten Ausführungsform als mit den Gewindebohrungen 18 zusammenwirkende Schrauben 32' aus einem beliebigen, passenden Material ausgebildet. Die Fixierung mittels der Schrauben 32' kann mit Unterlegscheibe/Schraubensicherungselement 50' - wie Federring, Sprengringe, Schnorrscheibe etc. - erfolgen, wie dies auf der linken Seite der **Fig. 2** dargestellt ist oder etwas weniger günstig ohne Unterlegscheibe und/oder ohne Schraubensicherungselemente (Federring, Schnorrscheibe etc.), wie dies auf der rechten Seite der **Fig. 2** dargestellt ist. Auch Unterlegscheibe/Schraubensicherungselement 50' sind in diesem Beispiel aus einem beliebigen passenden Material.

Die Leiterplatte 20 umfasst vorteilhafterweise einen Leiterplattenträger 40 und auf ihrer dem Bildsensor 22 zugewandten Seite eine Schaltkreisschicht 42, mit der der Bildsensor 22 elektrisch leitend verbunden ist. Wie in **Fig. 2** auf der linken Seite dargestellt, kann die Schaltkreisschicht 42 bei der Montage eingeklemmt werden zwischen Leiterplattenträger 40 und Objektivträger 16 oder die Schaltkreissicht 42 kann in diesem Bereich eine Aussparung 48 aufweisen, so dass sich Objektivträger 16 und Leiterplattenträger 40 hier berühren, wie dies auf der rechten Seite der **Fig. 2** dargestellt ist.

Wie aus **Fig. 2** erkennbar, ist in diesem Beispiel die Leiterplatte 20 mit dem darauf fixierten Bildsensor 22 so mit dem Objektivträger 16 verbunden, dass die durchgehende Öffnung 17 bzw. die Ausnehmung 25 durch die Leiterplatte 20 verschlossen wird. Vorteilhaft ist die Ausnehmung 25 auf diese Weise schmutz- bzw. staubdicht und noch besser auch bezüglich Feuchtigkeit dicht verschlossen. Hierzu kann auch eine entsprechende Dichtung, zum Beispiel mit Dichtungsgummi, Silikondichtung, Labyrinthdichtung etc. vorgesehen sein. Es ist aber auch denkbar, dass die Ausnehmung durch die Leiterplatte nach der Montage nicht dicht verschlossen ist oder gar etwas beabstandet von dem Objektivträger an diesem fixiert ist, was bei entsprechenden Anforderungen z.B. vorteilhaft in Bezug auf die Zugänglichkeit der Bauteile ist. Auch kommt es dann zu keiner Quetschung der Schaltkreisschicht bzw. es erübrigt sich dann eine entsprechende Aussparung in der Schaltkreisschicht.

Vorteilhafter Weise weist die Leiterplatte 20, wie in Fig. 2 gezeigt, eine Schaltkreisschicht 42 aus elektrisch isolierendem Material mit den vorbestimmten Schaltkreisen der Leiterplatte und evtl. weiteren elektrischen Bauteilen auf sowie einen Leiterplattenträger 40, der aus einem Material gefertigt ist, dessen thermischer Ausdehnungskoeffizient a_{L} um höchstens 25% bis 30% von dem thermischen Ausdehnungskoeffizienten a_{O} des Objektivträgers 16 abweicht. Dadurch werden thermische Spannungen zwischen Leiterplatte 20 und Objektivträger 16 vermieden, die zu Fehlern, insbesondere zu Messwertdrift führen können. Besser ist es, wenn der Unterschied zwischen den thermischen Ausdehnungskoeffizienten a_{L} (Leiterplatte) und a_{O} (Objektivträger) kleiner als 20%, besser noch kleiner 10% ist oder überhaupt möglichst klein ist. Besonders Vorteilhaft ist es, wenn der Leiterplattenträger 40 aus dem gleichen Material ist wie der Objektivträger 16 ist. Auch einer Lockerung der Schraubverbindung wird durch diese Materialwahl entgegengewirkt.

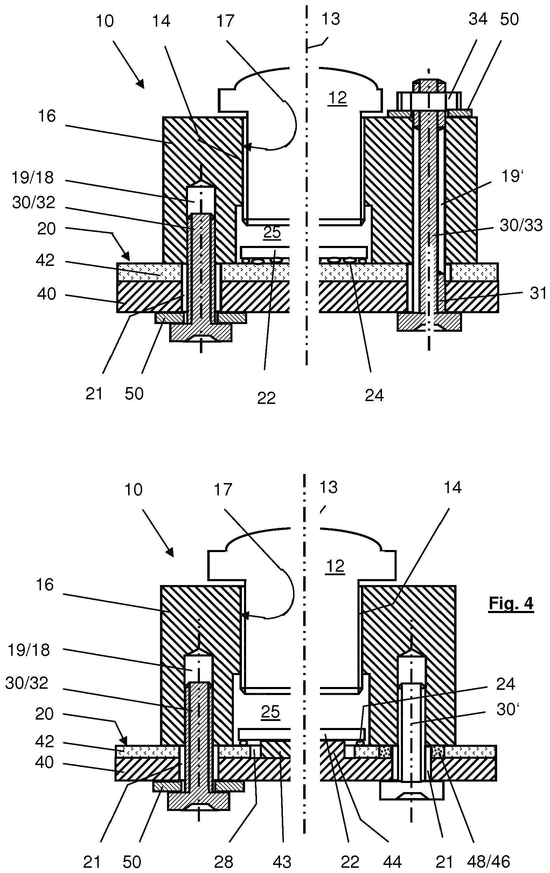

Den oben angesprochenen Messfehlern kann auch entgegengewirkt werden, indem die Verbindungselemente 30 aus einem Material gewählt werden, dessen thermischer Ausdehnungskoeffizient a_{V} demjenigen des Objektivträgers a_{O} ebenfalls möglichst ähnlich ist, so wie dies beispielsweise in **Fig. 3** gezeigt ist. Günstig sind auch hier Unterschiede in den Ausdehnungskoeffizienten von höchstens 25% bis 30%, besser höchstens 10%. Dies ist für sich genommen bereits eine sinnvolle Massnahme, um einer Lockerung der Schraubverbindung und damit Messfehlern entgegenzuwirken. Statt die Verbindungselemente 30 in Form von Schrauben 32 zu verwirklichen (dargestellt in **Fig. 3** auf der linken Seite), ist es auch denkbar sie in Form von Gewindebolzen 33 und Muttern 34 (dargestellt in Fig. 3 auf der rechten Seite) oder Durchsteckschrauben und Muttern, Nieten, etc. zu verwirklichen. Die Befestigungsausnehmungen 19 sind dann entsprechend als durchgehende Ausnehmungen 19' (rechts) ausgestaltet, die je nach Bedarf mit oder ohne Gewinde oder nur teilweise mit einem Gewinde versehen sind. Wird mit Gewindebolzen 33 und Muttern 34 oder Durchsteckschrauben und Muttern gearbeitet, ist es auch ausführbar den Leiterplattenträger 40 mit einem Gewinde 31 zu versehen (siehe rechte Seite, rechts unten in **Fig. 3**). Wiederum ist es möglich die Verbindung mit oder ohne Unterlegscheiben/Schraubensicherungselemente 50 zu realisieren. Wobei auch bezüglich der Unterlegscheiben/Schraubensicherungselemente 50 eine entsprechende Materialwahl mit angepasstem thermischem Ausdehnungskoeffizienten positiv ist.

Eine Weiterbildung des Kamerasystems 10 wie es anhand der Figuren 2 und 3 beschrieben ist, ist in **Fig. 4** dargestellt. Um nicht nur den Messfehlern, die ihren Ursprung in der Verbindung zwischen Leiterplatte 20 und Objektivträger 16 haben, zu begegnen (vgl. Ausführungsform der Figuren 2 und 3) ist in der in **Fig. 4** gezeigten Variante der Bildsensor 20 wiederum als SMD-Chip ausgebildet, aber in diesem Fall nur entlang seiner Ränder mit der Schaltkreisschicht 42 der Leiterplatte 20 elektrisch leitend verbunden. Unter dem Bildsensor 22 besitzt die Schaltkreisschicht 42 ein Loch 28. Durch dieses Loch 28 hindurch ist der Bildsensor 22 mittels eines Stützelements 43, 44 mit dem Leiterplattenträger 40 fest verbunden, wobei das Stützelement 43, 44 vorzugsweise aus dem gleichen Material gefertigt ist wie der Leiterplattenträger 40 oder aber zumindest aus einem Material mit einem sehr ähnlichen thermischen Ausdehnungskoeffizienten. Das Stützelement 43, 44 ist entweder als ein separates Bauteil 43 ausgeführt (links in **Fig. 4** dargestellt), das vorzugsweise durch Löten, Schweissen oder Kleben mit dem Leiterplattenträger 40 fix verbunden ist oder besser noch; es ist einstückig mit dem Leiterplattenträger 40 ausgebildet (Stützelement 44, rechts in **Fig. 4** dargestellt). Der Bildsensor 22 ist ebenfalls vorzugsweise durch entweder Löten, Schweissen oder Kleben mit dem Stützelement 43, 44 verbunden. Durch diese direkte Verbindung des Bildsensors 22 mit einem Material, das einen sehr ähnlichen, wenn nicht sogar den gleichen thermischen Ausdehnungskoeffizienten hat wie der Objektivträger 16, ist es möglich, thermisch induzierte Messfehler weiter zu reduzieren.

Wie dies in den **Fig. 3 und 4** angedeutet ist, ist es natürlich auch hier wieder möglich die Verbindung zwischen Leiterplatte 20 und Objektivträger 16 durch eine Schraub-, Niet- oder Bolzenverbindung zu realisieren, bei der die Schrauben 32' oder Bolzen und Muttern aus einem beliebeigen passenden Material gefertigt sind (rechts in **Fig. 4**) oder bei der die Schrauben 32 oder Bolzen und Muttern aus einem Material sind, das einen ähnlichen Ausdehnungskoeffizienten hat wie das Material des Objektivträgers 16 bzw. des Leiterplattenträgers 40 (links in **Fig. 4**). Beide Varianten sind wieder mit oder ohne Unterlegscheiben/Schraubensicherungselemente 50 realisierbar.

Wie bereites weiter oben beschreiben ist auch in Fig. 4 auf der rechten Seite dargestellt, dass die Schaltkreisschicht 42 im Bereich der Verbindung zwischen Leiterplatte 20 und Objektivträger 16 eine Aussparung 48 aufweist. In diesem Beispiel berühren sich aber Objektivträger 16 und Leiterplattenträger 40 nicht, wie oben in Fig. 2, sondern sie werden durch Druckresistente Abstandshalter 46 voneinander getrennt und auf Abstand gehalten, wobei der Abstand in diesem Fall etwa der Dicke der Schaltkreisschicht entspricht. Auf diese Weise kann verhindert werden, dass die Schaltkreissicht beim verbinden der Leiterplatte mit dem Objektivträger 16 gequetscht wird. Die Abstandhalter 48 können aber natürlich auch so gewählt werden, dass sie Leiterplatte 20 und Objektivträger 16 in einem viel grösseren Abstand zueinander beabstandet halten, so dass beispielsweise der Bildsensor 22 besser zugänglich bleibt.

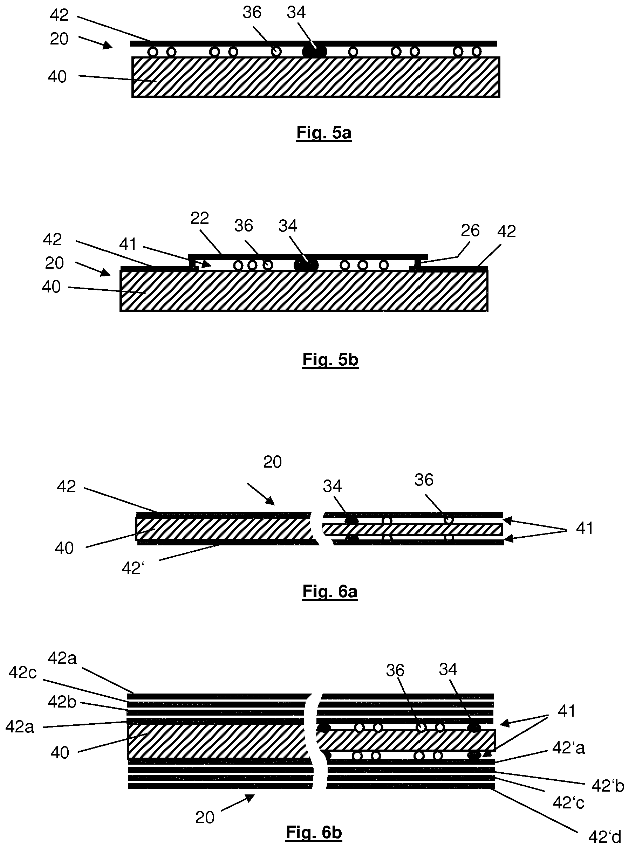

In **Fig. 5a** ist eine Schaltkreisschicht 42 gezeigt, die mittels einer schwimmenden Lagerung 41 mit einem Leiterplattenträger 40 verbunden ist. Schwimmend gelagert heisst, dass die Schaltkreisschicht 42 mittels bis zu drei harten Klebepunkten 34 - dargestellt ist die nur ein mittig angeordneter harter Klebepunkt 34 (was die bevorzugte Variante ist) - fest mit dem Leiterplattenträger 40 verbunden ist. Ebenfalls in **Fig. 5a** dargestellt sind optional mögliche weitere Verbindungen zwischen Schaltkreisschicht 42 und Leiterplattenträger 40 mittels weicher Klebepunkte 36. Je nach Größe der Schaltkreisschicht 42 und abhängig vom Material der Schaltkreisschicht 42 und des Leiterplattenträgers 40 benötigt man mehr als einen harten Klebepunkt 34 und keine, nur einige oder viele weiche Klebepunkte 36. Diese Art eine Schaltkreisschicht 42 auf einem Leiterplattenträger 40 zu befestigen reduziert Fehler, welche durch thermische Spannungen induziert werden können, und ist für alle Arten von Leiterplatten, wie sie in diesen Unterlagen beschrieben sind möglich. Ebenso möglich ist für alle hier beschriebenen Leiterplatten die mehr oder weniger ganzflächige Verklebung von Leiterplatte 40 und Schaltkreisschicht 42.

Die schwimmende Lagerung 41 mit harten und weichen Klebepunkten 34/36, wie sie in **Fig. 5a** für eine Schaltkreisschicht 42 dargestellt und erläutert ist, ist mit analogen Vorteilen auch für die Verbindung eines Bildsensors 22 mit einem Leiterplattenträger 40 einsetzbar (siehe **Fig. 5b**).

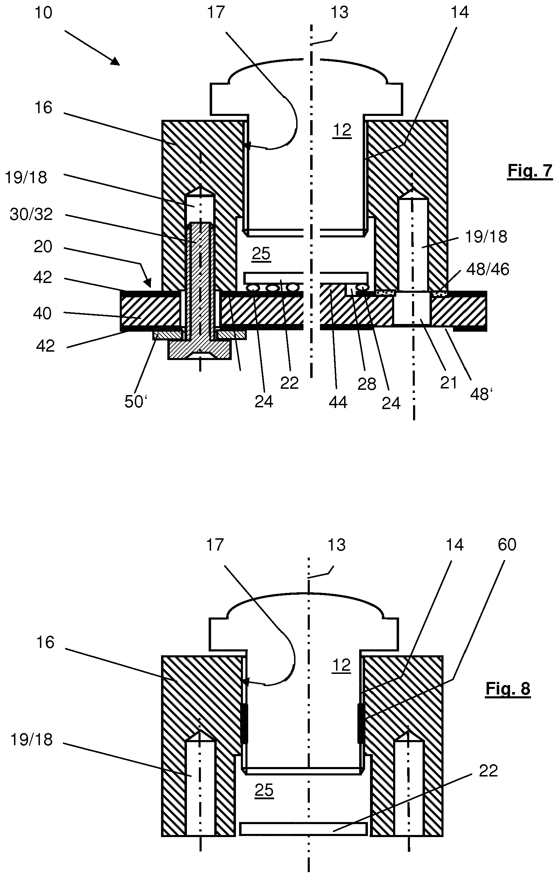

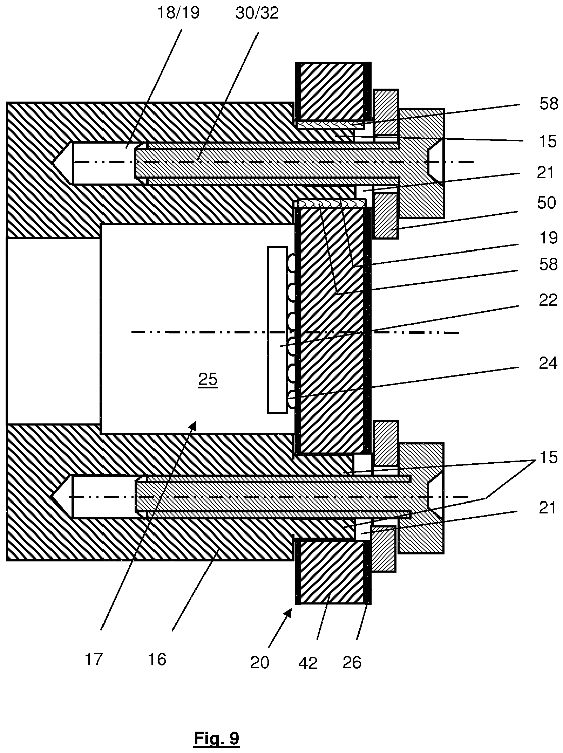

In **Fig. 6a** ist eine Leiterplatte 20 mit einem Leiterplattenträger 40 dargestellt, der auf beiden Seiten symmetrisch mit einer Schaltkreisschicht 42, 42' versehen ist. Wie in **Fig. 6b** dargestellt, können aber auch auf jeder Seite zwei und mehr Schaltkreisschichten 24a, 24b, 24c, 24d...; 24'a, 24'b, 24'c, 24'd,... vorgesehen sein, wobei die Anzahl Schaltkreisschichten auf den beiden Seiten vorteilhafterweise gleich ist. Auf diese Weise lassen sich thermische Spannungen die zu einer mechanischen Verbiegung der Leiterplatte 20 führen könnten, wie dies z.B. von Bi-Metallen bekannt ist, vermeiden. Aus diesem Grund werden Leiterplatten 20, wie hier in Fig.6a und 6b gezeigt, auch für die hier besprochenen Kamerasysteme 10 bevorzugt eingesetzt. Beispiele hierfür sind auch in den **Fig. 7** **und** **9** dargestellt. Die Schaltkreisschichten sind in der Regel mehr oder weniger ganzflächig miteinander verklebt und/oder verpresst. Ebenso möglich ist hier aber auch eine schwimmende Lagerung 41 jener dem Leiterplattenträger 40 unmittelbar benachbarten Schaltkreisschicht 42/42' bzw. 42a, 42'a auf dem Leiterplattenträger 40, wie dies jeweils auf der rechten Seite der **Fig. 6a/6b** dargestellt ist.

Wie eben ausgeführt weist der Leiterplattenträger 40 in der in **Fig. 7** dargestellten Ausführungsform, auf seiner dem Bildsensor 22 zugewandten Seite eine Schaltkreisschicht 42 auf und auf seiner dem Bildsensor 22 abgewandten Seite eine weitere Schaltkreisschicht 42'. Dies kann ebenso wie mehrlagige Leiterplatten (nicht dargestellt, Beschreibung siehe oben), abhängig von den Anforderungen, welche die Leiterplatte 20 erfüllen soll, sinnvoll sein. Die elektrisch leitende Verbindung des Bildsensors 22 mit der ihr zugewandten Schaltkreisschicht 42 ist verwirklicht wie für die Beispiele aus den Figuren 2 und 3 (siehe **Fig. 7** linke Seite), kann aber auch hier wieder verknüpft sein mit einer Fixierung des Bildsensors 22 mittels Stützelement 43/44 auf dem Leiterplattenträger 40 der Leiterplatte 20 durch ein Loch 28 der Schaltkreisschicht 42 hindurch (siehe **Fig. 7** rechte Seite). Die Verbindung zwischen Objektivträger 16 und Leiterplatte 20 ist wieder durch Schrauben 32 verwirklicht wobei die Schaltkreisschichten 42, 42' wieder entweder gequetscht werden, siehe Darstellung auf der linke Seite der **Fig. 7****,** oder aber das Quetschen wird vermieden durch auf der Seite des Bildsensors 22 durch Abstandshalter 46 in einer Aussparungen 48 und auf der gegenüberliegenden Seite, indem um die Befestigungsöffnung eine Aussparung 48' vorgesehen ist, in welche beispielsweise. auch eine Unterlagscheibe/Schraubenscherung 50, 50' mit angepasster Dicke hineinpasst und somit gleichzeitig auch als Abstandshalter wirken kann, so wie dies auf der rechten Seite der **Fig. 7** dargestellt ist.

In **Fig. 9** ist in Vergrösserung ein Ausschnitt einer weiteren Variante des Kamerasystems 10 dargestellt. Die Leiterplatte 20 ist hier als Leiterplatte 20 mit einem Leiterplattenträger 40 und zwei einander gegenüberliegenden Schaltkreisschichten 42, 42' dargestellt, wobei der Bildsensor 22 mittels Ball Grid Array elektrisch leitend mit der ihr zugewandten Schaltkreisschicht 42 der Leiterplatte 20 verbunden ist. Es versteht sich aber, dass auch alle oben ausgeführten Varianten der Leiterplatte und der Befestigung bzw. elektrischen Verbindung 24 zwischen Leiterplatte 20 und Bildsensor 22 verwirklicht sein können, inklusive derjenigen mit dem Stützelement 43, 44. Ebenso können alle oben beschriebenen Varianten der Verbindung zwischen Leiterplatte 20 und Objektivträger 16 verwirklicht sein.

Speziell an der hier gezeigten Verbindung zwischen Leiterplatte 20 und Objektivträger 16 ist, dass der Objektivträger 16 im Bereich der Befestigungsausnehmungen 19, 19' für die Aufnahme von Verbindungselementen 30, 30' Positionierungsflansche 15 aufweist, die vom eigentlichen Objektivträger in Richtung der zu montierenden Leiterplatte 20 abstehen und vorzugsweise die Ausnehmungen 19, 19' umgeben bzw. diese in Richtung der zu montierenden Leiterplatte fluchtend verlängern. Die Befestigungsöffnungen 21 in der Leiterplatte sind so ausgestaltet, dass sie diese Positionierflansche 15 mit ganz geringer Toleranz, z.B. H7/h6, oder besser noch in Form einer Presspassung aufnehmen, wie dies auf der linken Seite der **Fig. 9** dargestellt ist. Auch Geometrien mit definierter Verformungszone sind hier denkbar, so dass z.B. Zylinder in ein Rechteckloch eingepresst werden, wodurch der erforderliche Kraftaufwand für diese Teilpressung geringer ist als für eine normale Presspassung. Insbesondere für Laserkollimatoren sind auch sternförmig gerändelte Löcher für einen besseren Toleranzausgleich denkbar. Auf diese Weise wird die Verbindung zwischen Leiterplatte 20 und insbesondere dem Leiterplattenträger 40 und dem Objektivträger 16 weiter verbessert.

Eine weitere Option (bei der die Fertigungstoleranzen der Befestigungsöffnungen 21 und der Positionierflansche 15 etwas größer sein können) ist auf der rechten Seite der **Fig. 9** dargestellt. Hier werden die Aussenseiten der Positionierflansche 15 und/oder die Innenseite der Befestigungsöffnungen 21 mit langsam aushärtendem Klebstoff 58 versehen. Ist die Verbindung mittels der Verbindungselemente 30, 30' installiert und der Klebstoff 58 ausgehärtet, sind Leiterplatte 20 und Objektivträger 16 miteinander verklebt und Verschiebungen der Leiterplatte 20 gegenüber dem Objektivträger 16 nahezu ausgeschlossen.

Als sehr günstige Verbindung in Bezug auf die thermische Stabilität haben sich herausgestellt ein Objektivträger aus Aluminium bzw. Aluminiumlegierung sowie ein Leiterplattenträger ebenfalls aus Aluminium bzw. einer möglichst gleichen Aluminiumlegierung und verbunden mittels eines Klebstoffs, der einen möglichst ähnlichen thermischen Ausdehnungskoeffizient wie das Aluminium bzw. die Aluminiumlegierung(en) aufweist.

Bei Messgeräten, bei denen die Distanzvarianz gering ist, welche durch das Kamerasystem 10 erfassbar sein muss, lässt sich noch eine andere Massnahme verwirklichen, um Messfehler zu vermeiden. Das Objektiv 14 wird in den Objektivträger 16 eingeklebt, und zwar auf einer Position, die bei der geforderten Abbildungsdistanz ein scharfes Bild auf dem Bildsensor 22 erzeugt, wie dies in **Fig. 8** an einem Ausschnitt einer weiteren Variante des Kamerasystems 10 gezeigt ist. Hierfür wird beispielsweise ein langsam aushärtender Klebstoff 60 auf das Innengewinde der Aufnahmeöffnung 17 des Objektivträgers 16 und/oder auf das Aussengewinde 14 des Objektivs 12 aufgebracht. Das Objektiv 14 wird in den Objektivträger 16 eingeschraubt auf eine Position, die bei der geforderten Abbildungsdistanz ein scharfes Bild auf dem Bildsensor 22 erzeugt und dort ruhen gelassen, bis der Klebstoff 60 ausgehärtet ist. Ähnlich lässt sich das Objektiv natürlich auch einkleben, wenn es statt in den Objektivträger eingeschraubt zu werden, in eine Gleitpassung des Objektivträgers eingeschoben wird, wie dies dem Fachmann bekannt ist, und auf eine fokussierende Position gebracht wurde.

Vorteilhafter Weise wird für alle genannten Verklebungen jeweils ein Klebstoff 58/60 verwendet, der entweder in der Lage ist, Spannungen aufgrund thermischer Ausdehnungsunterschiede zwischen den aneinander angrenzenden Materialien aufzunehmen, so dass er unterschiedliche Ausdehnungen dieser Materialien auszugleichen vermag.

Noch besser ist es freilich Materialpaarungen mit gleichem oder sehr ähnlichem thermischen Ausdehnungskoeffizienten zu verwenden und sie mittels eines Klebstoffs miteinander zu verkleben, der einen ähnlichen Ausdehnungskoeffizienten hat wie diese Materialien. So wäre es z.B. sehr Vorteilhaft den Tubus des Objektivs und den Objektivträger aus dem gleichen Material, wie beispielsweise aus Aluminium bzw. der gleichen Al-Legierung zu fertigen und mit einem Zweikomponenten-Epoxidkleber, wie er oben beschriebenen ist, miteinander zu verkleben.

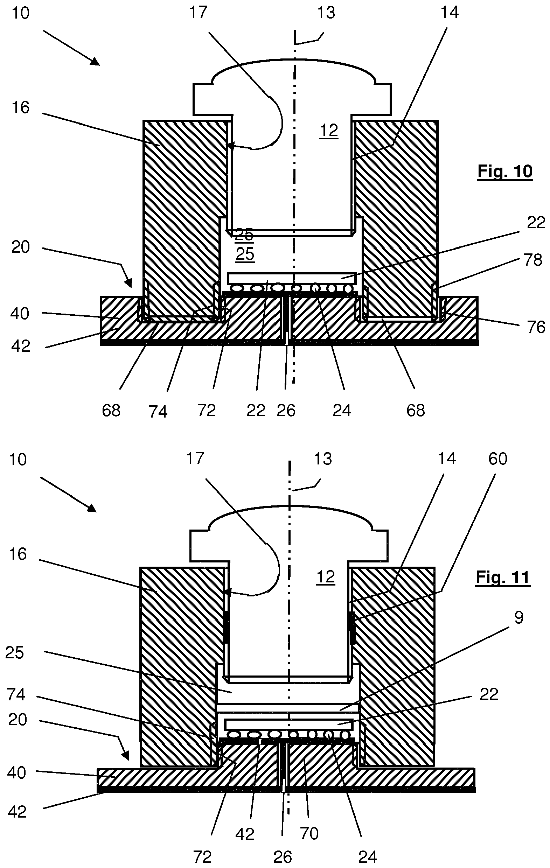

In **Fig. 10** ist eine Ausführungsform gezeigt, bei der der Objektivträger 16 an seinem dem Objektiv 12 gegenüberliegenden Ende Aussen und Innen zylindrisch ausgebildet ist und im Bereich dieses Zylinders entsprechend ein Aussengewinde 78 und ein Innengewinde 74 aufweist. Der Leiterplattenträger 40 der Leiterplatte 20 ist etwas dicker ausgebildet und mit einer entsprechenden nutförmigen Ausnehmung 68 mit gegengleich ausgebildeten Innen- bzw. Aussengewinde 72, 76 ausgestattet, so dass der Objektivträger 16 in die Leiteplatte 20 einschraubbar ist, bzw. die Leiterplatte 20 auf den Objektivträger 16 aufschraubbar. Es versteht sich dass in der nut 68 auch nur ein Innengewinde 76 oder nur ein Aussengewinde 72 vorgesehen sein kann mit einem entsprechenden Gewinde 74, 78 am Objektivträger 16. Mittig bezüglich dieser Schraubverbindung ist der Bildsensor 22 in bekannter Weise mit einer Schaltkreisschicht 42 der Leiterplatte 20 verbunden. Die Leiterplatte 42 mit dem Bildsensor 22 ist in diesem Beispiel mittels einer durch den Leiterplattenträger 40 hindurch geführten elektrischen Verbindung 26 mit der Schaltkreisschicht 42' auf der gegenüberliegenden Seite des Leiterplattenträgers 40 verbunden. Die elektrisch leitende Verbindung 26 ist über eine durchgehende Öffnung im Leiterplattenträger 40 realisiert, durch die ein isoliertes Kabel hindurchgeführt ist, oder welches für einen definierten elektrischen Kontakt an seinen Wänden mit isolierendem Lack beschichtet ist und dann mit einem elektrisch leitenden Material ausgefüllt ist, wie z.B. mit elektrisch leitendem Kunststoff, elektrisch leitendem Klebstoff, elektrisch leitendem Lack, elektrisch leitendem Lötzinn.

In **Fig. 11** ist eine Variante des Kamerasystems 10 aus Fig. 10 dargestellt, wobei hier die Leiterplatte 20 mittig eine Art zylindrischen Stempel mit Aussengewinde 72 aufweist, welche den Bildsensor 22 trägt und auf welchen der Objektivträger 16 mit einem Innengewinde 74 aufgeschraubt ist. Des Weiteren ist beispielhaft in dieser Ausführungsform im Hohlraum 25 des Objektivträgers 16 ein Filter 9 vorgesehen, der im optischen Pfad des Kamerasystems dem Bildsensor 22 vorgelagert ist. Bei diesem Filter 9 kann es sich beispielsweise um einen IR-Filter, einen Graufilter oder einen sonstigen Spektralfilter etc. handeln.

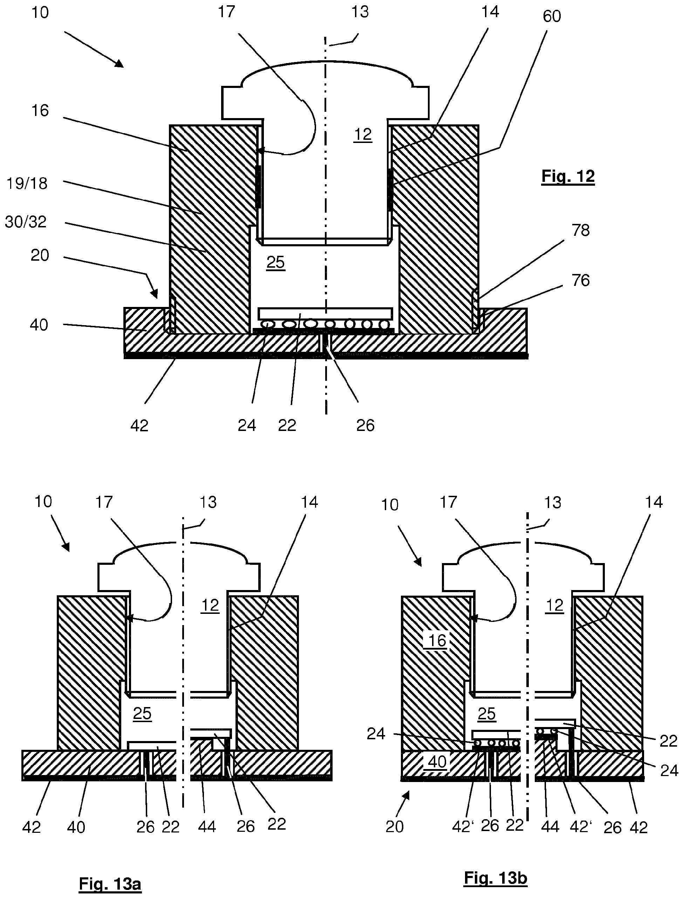

Eine weitere Variante des Kamerasystems 10 aus Fig. 10 ist in **Fig. 12** dargestellt, wobei bei dieser Variante der Leiterplattenträger 40 mittig eine Art zylindrische Vertiefung mit Innengewinde 76 zur Aufnahme eines Objektivträgers 16 mit entsprechendem Aussengewinde 78 dient.

In den in **Fig. 13a und 13b** gezeigten Ausführungsformen des Kamerasystems 10 sind Objektivträger 16 und Leiterplatte 20 miteinander verschweisst bzw. miteinander verlötet. Der Leiterplattenträger 40 weisst in der in **Fig. 13a** gezeigten Variante dieser Ausführungsform nur auf seiner dem Objektiv 12 abgewandten Seite eine Schaltkreisschicht 42 auf. Der in der Ausnehmung 25 angeordnete Bildsensor 22 ist direkt auf dem Leiterplattenträger 40 fixiert und durch eine elektrische Verbindung 26 wie sie bereits für **Fig. 10** beschrieben wurde, mit dieser Schaltkreisschicht 42 verbunden. Die Variante in **Fig. 13b** ist nahezu gleich ausgebildet, nur dass Objektivträger 16 und Leiterplattenträger 40 bei dieser Variante miteinander verklebt sind und der Leiterplattenträger 40 auch im Bereich unter dem Bildsensor 22 eine Schaltkreisschicht 42' aufweist. Die Fixierung des Bildsensors 22 auf der Leiterplatte 20 bzw. dem Leiterplatteträger 40 kann als elektrisch leitende Verklebung realisiert sein, auch in Form einer oben beschriebenen "schwimmenden Lagerung". Je nach Anforderung ist es aber ebenso denkbar, die Verbindung zwischen Bildsensor 22 und Leiterplatte 20 mittels Ball-Grid-Array herzustellen. Der Leiterplattenträger kann auf seiner dem Objektiv 12 zugewandten Seite flach ausgebildet sein, so wie das jeweils links in den **Fig. 13a, 13b** dargestellt ist, oder sie kann mittig eine Erhöhung für die Aufnahme des Bildsensors 22 aufweisen, wie dies jeweils auf der rechten Seite in den **Fig. 13a, 13b** dargestellt ist.

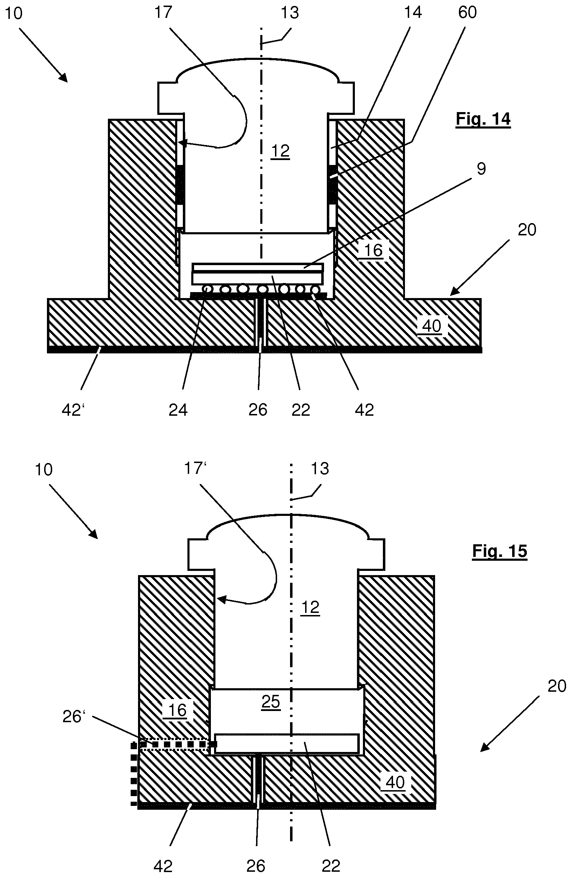

In noch einer weiteren Ausführungsform, wie sie in den **Fig. 14 und 15** dargestellt ist, sind Objektivträger 16 und Leiterplattenträger 40 einstückig ausgebildet, wobei in **Fig. 14** der Leiterplattenträger 40 zumindest auf seiner dem Objektiv 12 zugewandten und die Ausnehmung 25 begrenzenden Oberfläche eine Schaltkreisschicht 42 aufweist, mit welcher der in der Ausnehmung 25 fixierte Bildsensor 22 elektrisch leitend verbunden ist. Durch eine elektrische leitende Verbindung 26, welche durch den Leiterplattenträger 40 hindurch geführt ist, ist diese unter dem Bildsensor 22 angeordnete Schaltkreisschicht 42 elektrisch leitend mit einer auf der gegenüberliegenden Seite des Leiterplattenträgers 40 angebrachten weiteren Schaltkreisschicht 42' verbunden. Direkt auf dem Bildsensor 22 ist beispielhaft in dieser Ausführungsform ein Filter 9 aufgebracht, z.B. aufgeklebt. Bei diesem Filter 9 kann es sich um beispielsweise um einen IR-Filter, einen Graufilter oder einen sonstigen Spektralfilter etc. handeln.

Die Variante in **Fig. 15** ist nahezu identisch ausgebildet zu jener in **Fig. 14****,** nur dass unter dem Bildsensor 22 - anders als in Fig. 14 - keine Schaltkreisschicht angeordnet ist. Statt dessen ist analog zu den Varianten aus **Fig. 13a** eine elektrische Verbindung 26 zu einer Schaltkreisschicht 42 auf der dem Bildsensor 22 gegenüberliegenden Seite des Leiterplattenträgers 40 vorgesehen. Diese elektrisch leitende Verbindung kann, wie mit dem Bezugszeichen 26 angedeutet, durch die Leiterplatte 20 bzw. mindestens den Leiterplattenträger 40 hindurch geführt sein, oder wie mit der gestrichelten Linie 26' angedeutet, seitlich durch den Objektivträger 16 geführt sein. Wie in der Ausführungsform der Fig. 15 angedeutet, ist es auch möglich ein solches Kamerasystem 10 zu realisieren, indem das Objektiv 12 nicht mittels eines Gewindes mit dem Objektivträger 16 verbunden und dann evtl. noch mit diesem verklebt wird, sondern indem das Objektiv 12, in eine Gleitpassung 17' des Objektivträgers 16 eingesetzt wird. Dies insbesondere wenn das Objektiv 12 als ein Linsen und/oder weitere optische Elemente - wie beispielsweise auch Filter - enthaltender Tubus gestaltet ist. Das Objektiv 12 kann dann beispielsweise durch einen Klemmmechanismus oder einen Bajonettverschluss etc. im Objektivträger gesichert sein und je nach Anforderung an das Kamerasystem optional auch zusätzlich noch verklebt sein.

Wie aus den verschiedenen Darstellungen klar hervorgeht, können die einzelnen anhand der Figuren beschriebenen Massnahmen zur Fehlerminimierung des Kamerasystems in verschiedenster Weise miteinander kombiniert werden. Dem Fachmann ist klar, daß und in welcher Weise sich die beschriebenen Ausführungsformen bzw. die anhand der Ausführungsbeispiele beschriebenen Details, innerhalb des durch die Ansprüche definierten Schutzbereichs sinnvoll kombinieren lassen. Aus Platzgründen ist es aber nicht möglich alle möglichen und sinnvollen Kombinationen im Detail figürlich darzustellen und/oder zu beschreiben.

## Patentansprüche

1. Kamerasystem (10) für Messanwendungen umfassend
• ein Objektiv (12) mit mindestens einer Objektivlinse und optional mit einem die wenigstens eine Objektivlinse aufnehmenden Tubus;
• einen das Objektiv (12) tragenden Objektivträger (16) ;
• einen Bildsensor (22); und
• eine Leiterplatte (20)
• wobei die Leiterplatte (20) und der Bildsensor (22) elektronisch leitend miteinander verbunden sind, und
• der Objektivträger (16) eine Aufnahmeöffnung (17) mit einem Innengewinde aufweist und das Objektiv (12) ein Aussengewinde (14) aufweist, mit dem es in das Innengewinde der Aufnahmeöffnung (17) des Objektivträgers (16) so einschraubbar ist, dass
• der Bildsensor (22) und das Objektiv (12) so zueinander angeordnet sind, dass ein über das Objektiv (12) auf den Bildsensor projiziertes Bild scharf abbildbar ist;
**dadurch gekennzeichnet, daß**
Klebstoff (60) auf das Innengewinde der Aufnahmeöffnung (17) des Objektivträgers (16) und/oder auf das Aussengewinde (14) des Objektivs (12) aufgebracht ist und das Objektiv (14) auf jener Position im Objektivträger (16) mit diesem verklebt ist, auf der ein scharfes Bild auf dem Bildsensor (22) abbildbar ist, wobei der verwendete Klebstoff einen thermischen Ausdehnungskoeffizienten im Bereich von a_{K}=20^{∗}10⁻⁶/K bis 27^{∗}10⁻⁶/K aufweist und vorzugsweise eine Härte im Bereich von 75 bis 95 Shore D; und
der Objektivträger (16) und die Leiterplatte (20) oder zumindest ein Leiterplattenträger (40) der Leiterplatte (20) aus Materialien gefertigt sind, deren thermische Ausdehnungskoeffizienten um höchstens 30% voneinander abweichen.

2. Kamerasystem (10) nach Anspruch 1,
**dadurch gekennzeichnet, daß**
die Leiterplatte (20) als FR4-Board gefertigt ist mit einem thermischen Ausdehnungskoeffizienten in der x-y-Ebene im Bereich von a_{L}=12^{∗}10⁻⁶/K bis 14^{∗}10⁻⁶/K und der Objektivträger (16) aus einem rostfreien Stahl hergestellt ist, dessen thermischer Ausdehnungskoeffizient ebenfalls im Bereich von a_{O}=10^{∗}10⁻⁶/K bis 16^{∗}10⁻⁶/K liegt.

3. Kamerasystem (10) nach Anspruch 1,
**dadurch gekennzeichnet, daß**
die Leiterplatte (20) einen Leiterplattenträger (40) umfasst, auf dem mindestens eine Schaltkreisschicht (42) angeordnet ist, wobei
• die Schaltkreisschicht (42) im Wesentlichen aus elektrisch isolierendem Material hergestellt ist und mit den vorbestimmten Schaltkreisen der Leiterplatte (20) versehen ist, und
• wobei der Leiterplattenträger (40), aus einem Material gefertigt ist, dessen thermischer Ausdehnungskoeffizient a_{L} um höchstens 30% vom thermischen Ausdehnungskoeffizienten a_{O} des Materials abweicht, aus dem der Objektivträger (16) gefertigt ist, wobei
• das Material aus dem der Objektivträger (16) gefertigt ist bzw. das Material aus dem der Leiterplattenträger (40) hergestellt ist, insbesondere ein Material aus folgender Gruppe von Materialien ist; Kupfer, Kupferlegierungen, wie Messing und Bronze, rostfreier Stahl, Magnesiumlegierungen, Aluminium, Aluminiumlegierungen, insbesondere Aluminiumknetlegierungen, Titan, Glas, Glaskeramik.

4. Kamerasystem (10) nach Anspruch 3,
**dadurch gekennzeichnet, daß**
der Leiterplattenträger (40) und der Objektivträger (16) aus dem gleichen Material gefertigt sind.

5. Kamerasystem (10) nach einem der Ansprüche 1, 3 oder 4,
**dadurch gekennzeichnet, daß**
Objektiv, Objektivträger (16) und Leiterplattenträger (20) jeweils aus einem Material gefertigt sind, dessen thermischer Ausdehnungskoeffizient um höchstens 30% vom thermischen Ausdehnungskoeffizienten der wenigstens einen Objektivlinse abweicht, wobei Objektivträger, Leiterplattenträger und der optional vorhandene Tubus insbesondere aus Glaskeramik oder Titan gefertigt sind.

6. Kamerasystem (10) nach Anspruch 1,
**dadurch gekennzeichnet, daß**
der Leiterplattenträger aus einem Material gefertigt ist, dessen thermischer Ausdehnungskoeffizient um höchstens 30% vom thermischen Ausdehnungskoeffizienten des Bildsensors/Kamerachips (22) abweicht.

7. Kamerasystem (10) nach einem der vorherigen Ansprüche, **da**
**durch gekennzeichnet, daß**
Klebeverbindungen im Kamerasystem als thermisch stabile Klebungen ausgeführt sind, indem
der thermische Ausdehnungskoeffizient des verwendeten Klebstoffs höchstens um 30% von demjenigen der Materialien abweicht aus dem die zu verbindenden Bauteile gefertigt sind

8. Kamerasystem nach Anspruch 7,
**dadurch gekennzeichnet, daß**
der verwendete Klebstoff einen thermischen Ausdehnungskoeffizienten im Bereich von a_{K}=22^{∗}10⁻⁶/K bis 25^{∗}10⁻⁶/K aufweist und vorzugsweise eine Härte im Bereich von 75 bis 95 Shore D.

9. Kamerasystem (10) nach einem der vorhergehenden Ansprüche,
**dadurch gekennzeichnet, daß**
der Leiterplattenträger (40) auf seiner dem Bildsensor (22) zugewandten Seite wenigstens eine Schaltkreisschicht (42, 42a, 42b, 42c, ...) aufweist und auf seiner dem Bildsensor (22) abgewandten Seite wenigstens eine weitere Schaltkreisschicht (42', 42'a, 42'b, 42'c, ...) aufweist, insbesondere wobei die Anzahl Schaltkreisschichten auf beiden Seiten gleich ist, so dass sich ein symmetrischer Schichtaufbau ergibt.

10. Kamerasystem (10) nach einem der vorherigen Ansprüche,
**dadurch gekennzeichnet, daß**
• dass der Objektivträger (16) für die Aufnahme von Verbindungselementen (30, 30') Befestigungsausnehmungen (19, 19') aufweist und im Bereich dieser Befestigungsausnehmungen (19, 19') mit Positionierungsflanschen (15) versehen ist, welche in Richtung der zu montierenden Leiterplatte (20) abstehen, wobei vorzugsweise die Positionierungsflansche (15) die Befestigungsausnehmungen (19, 19') fluchtend verlängern; und
• die Befestigungsöffnungen (21) in der Leiterplatte (20) so ausgestaltet sind, dass sie die Positionierflansche (15) aufnehmen.

11. Kamerasystem (10) nach Anspruch 10,
**dadurch gekennzeichnet, daß**
in montiertem Zustand
• die Positionierflansche (15) des Objektivträgers (16) in den Befestigungsöffnungen (21) der Leiterplatte (20) mit ganz geringem Spiel, z.B. H7/g6; aufgenommen sind
oder
• die Positionierflansche (15) des Objektivträgers (16) in den Befestigungsöffnungen (21) der Leiterplatte (20) in einer Presspassung aufgenommen sind
oder
• die Positionierflansche (15) des Objektivträgers (16) in die Befestigungsöffnungen (21) der Leiterplatte (20) eingeklebt sind, insbesondere mit einem Klebstoff mit einem zum Ausdehnungskoeffizienten der Leiterplatte bzw. des Objektivträgers ähnlichem Ausdehnungskoeffizient, nämlich mit einer Abweichung hiervon von höchstens 30%.

12. Kamerasystem (10) nach einem der Ansprüche 1 bis 9,
**dadurch gekennzeichnet, daß**
• der Objektivträger (16) und der Leiterplattenträger (40) jeweils Gewinde (72, 74, 76, 78) aufweisen, mittels derer sie derart miteinander verschraubt sind, dass diese ineinandergreifen
oder
• Objektivträger (16) und der Leiterplattenträger (40) miteinander verschweisst, verlötet oder verklebt sind.

13. Kamerasystem (10) nach einem der Ansprüche 1 bis 9, **da**
**durch gekennzeichnet, daß**
Objektivträger (16) und Leiterplattenträger (40) einstückig ausgebildet sind.

14. Kamerasystem (10) nach einem der Ansprüche 3 bis 13,
**dadurch gekennzeichnet, daß**
der Bildsensor (22) schwimmend auf dem Leiterplattenträger (40) gelagert ist, wobei er maximal mittels dreier harter Klebepunkte (34), besser nur mittels eines harten Klebepunkts (34), fest mit dem Leiterplattenträger (40) verbunden ist und optional mittels weiterer weicher Klebepunkte (36).

## Claims

1. Camera system (10) for measurement applications, comprising
• an objective (12) with at least one objective lens and optionally with a tube that receives the at least one objective lens;
• an objective holder (16) that carries the objective (12) ;
• an image sensor (22); and
• a printed circuit board (20),
∘ wherein the printed circuit board (20) and the image sensor (22) are connected to one another in an electronically conductive manner, and
∘ the objective holder (16) has a reception opening (17) with an internal thread and the objective (12) has an external thread (14) with which it can be screwed into the internal thread of the reception opening (17) of the objective holder (16) so that
∘ the image sensor (22) and the objective (12) are arranged in relation to one another in such a way that an image that is projected onto the image sensor by way of the objective (12) is imageable in focus;
**characterized in that**
adhesive (60) is applied to the internal thread of the reception opening (17) of the objective holder (16) and/or to the external thread (14) of the objective (12) and the objective (12) is adhesively bonded to the objective holder (16) at that position on which a sharp image can be imaged on the image sensor (22), wherein the employed adhesive has a coefficient of thermal expansion in the region of a_{K}=20^{∗}10⁻⁶/K to 27^{∗}10⁻⁶/K and preferably has a hardness in the region of 75 to 95 Shore D; and
the objective holder (16) and the printed circuit board (20) or at least a printed circuit board substrate (40) of the printed circuit board (20) are manufactured from materials, the coefficients of thermal expansion of which deviate from one another by no more than 30%.

2. Camera system (10) according to Claim 1, **ch**
**aracterized in that**
the printed circuit board (20) is manufactured as an FR4 board with a coefficient of thermal expansion in the xy-plane in the region of a_{L}=12^{∗}10⁻⁶/K to 14^{∗}10⁻⁶/K and the objective holder (16) is produced from a stainless steel, the coefficient of thermal expansion of which likewise lies in the region of a_{O}=10^{∗}10⁻⁶/K to 16^{∗}10⁻⁶/K.

3. Camera system (10) according to Claim 1,
**characterized in that**
the printed circuit board (20) comprises a printed circuit board substrate (40), on which at least one circuit layer (42) is arranged, wherein
• the circuit layer (42) is substantially produced from electrically insulating material and provided with the predetermined circuits of the printed circuit board (20), and
• wherein the printed circuit board substrate (40) is manufactured from a material, the coefficient of thermal expansion a_{L} of which deviates by no more than 30% from the coefficient of thermal expansion ao of the material from which the objective holder (16) is manufactured, wherein
• the material from which the objective holder (16) is manufactured or the material from which the printed circuit board substrate (40) is produced is, in particular, a material from the following group of materials: copper, copper alloys such as brass and bronze, stainless steel, magnesium alloys, aluminum, aluminum alloys, in particular wrought aluminum alloys, titanium, glass, glass ceramics.

4. Camera system (10) according to Claim 3,
**characterized in that**
the printed circuit board substrate (40) and the objective holder (16) are manufactured from the same material.

5. Camera system (10) according to any one of Claims 1, 3 or 4,
**characterized in that**
objective, objective holder (16) and printed circuit board substrate (20) are each manufactured from a material, the coefficient of thermal expansion of which deviates by no more than 30% from the coefficient of thermal expansion of the at least one objective lens, wherein objective holder, printed circuit board substrate and the optionally present tube are manufactured from, in particular, glass ceramics or titanium.

6. Camera system (10) according to Claim 1,
**characterized in that**
the printed circuit board substrate is manufactured from a material, the coefficient of thermal expansion of which deviates by no more than 30% from the coefficient of thermal expansion of the image sensor/camera chip (22).

7. Camera system (10) according to any one of the preceding claims,
**characterized in that**
adhesive connections in the camera system are embodied as thermally stable adhesive bonds, by virtue of,
the coefficient of thermal expansion of the employed adhesive deviating by no more than 30% from that of the materials from which the components to be connected are manufactured

8. Camera system according to Claim 7,
**characterized in that**
the employed adhesive has a coefficient of thermal expansion in the region of a_{K}=22^{∗}10⁻⁶/K to 25^{∗}10⁻⁶/K and preferably has a hardness in the region of 75 to 95 Shore D.

9. Camera system (10) according to any one of the preceding claims,
**characterized in that**
the printed circuit board substrate (40) has at least one circuit layer (42, 42a, 42b, 42c, ...) on its side that faces the image sensor (22) and has at least one further circuit layer (42', 42'a, 42'b, 42'c, ...) on its side that faces away from the image sensor (22), in particular wherein the number of circuit layers on both sides is the same such that a symmetrical layer structure emerges.

10. Camera system (10) according to any one of the preceding claims,
**characterized in that**
• **in that** the objective holder (16) has attachment recesses (19, 19') for receiving connecting elements (30, 30') and is provided with positioning flanges (15) in the region of these attachment recesses (19, 19'), said positioning flanges projecting in the direction of the printed circuit board (20) to be assembled, wherein, preferably, the positioning flanges (15) lengthen the attachment recesses (19, 19') in a flush manner; and
• the attachment openings (21) in the printed circuit board (20) are configured in such a way that they receive the positioning flanges (15).

11. Camera system (10) according to Claim 10,
**characterized in that,**
in the assembled state,
• the positioning flanges (15) of the objective holder (16) are received in the attachment openings (21) of the printed circuit board (20) with very little play, e.g. H7/g6;
or
• the positioning flanges (15) of the objective holder (16) are received in the attachment openings (21) of the printed circuit board (20) with a press fit,
or
• the positioning flanges (15) of the objective holder (16) are adhesively bonded into the attachment openings (21) of the printed circuit board (20), in particular with an adhesive with a coefficient of expansion similar to the coefficient of expansion of the printed circuit board or of the objective holder, namely with a deviation therefrom of at most 30%.

12. Camera system (10) according to any one of Claims 1 to 9,
**characterized in that**
• the objective holder (16) and the printed circuit board substrate (40) each have threads (72, 74, 76, 78), by means of which they are screwed into one another in such a way that these engage with one another,
or
• the objective holder (16) and the printed circuit board substrate (40) are welded, soldered or adhesively bonded to one another.

13. Camera system (10) according to any one of Claims 1 to 9,
**characterized in that**
the objective holder (16) and the printed circuit board substrate (40) have an integral embodiment.

14. Camera system (10) according to any one of Claims 3 to 13,
**characterized in that**
the image sensor (22) is mounted on the printed circuit board substrate (40) in a floating fashion, wherein it is securely connected to the printed circuit board substrate (40) by means of at most three hard adhesive spots (34), better only by means of one hard adhesive spot (34), and optionally by means of further soft adhesive spots (36).

## Revendications

1. Système de caméra (10) pour des applications de mesure comprenant
• un objectif (12) avec au moins une lentille d'objectif et en option avec un tube qui loge la au moins une lentille d'objectif ;
• un support d'objectif (16) qui porte l'objectif (12) ;
• un capteur d'image (22) et
• une carte imprimée (20)
• cependant que la carte imprimée (20 et le capteur d'image (22) sont reliés électroniquement l'un à l'autre et
• le support d'objectif (16) présente une ouverture de réception (17) avec un filet intérieur et l'objectif (12) un filet extérieur (14) avec lequel il peut être vissé dans le filet intérieur de l'ouverture de réception (17) du support d'objectif (16) de telle manière que
• le capteur d'image (22) et l'objectif (12) sont placés l'un par rapport à l'autre de telle manière qu'une image projetée sur le capteur d'image via l'objectif (12) puisse être représentée de façon nette,
**caractérisé en ce que**
de la colle (60) est appliquée sur le filet intérieur de l'ouverture de réception (17) du support d'objectif (16) et/ou sur le filet extérieur (14) de l'objectif (12) et l'objectif (12) est collé sur la position dans le support d'objectif (16) à celui-ci sur laquelle une image nette sur le capteur d'image (22) peut être représentée, cependant que la colle utilisée présente un coefficient de dilatation thermique de l'ordre de a ₖ=20^{∗}10⁻⁶/K à 27^{∗}10⁻⁶/K et de préférence une dureté de l'ordre de 75 à 95 Shore D et
le support d'objectif (16) et la carte imprimée (20) ou au moins un support de carte imprimée (40) de la carte imprimée (20) sont fabriqués en matériaux dont les coefficients de dilatation thermique différent d'au plus 30% l'un de l'autre.

2. Système de caméra (10) selon la revendication 1, **caractérisé en ce que** la carte imprimée (20) est réalisée comme carte en FR4 avec un coefficient de dilatation thermique dans le plan x-y de a_{L}=12^{∗}10⁻⁶/K à 14^{∗}10⁻⁶/K et le support d'objectif (16) est fabriqué en un acier inoxydable dont le coefficient de dilatation thermique se situe également de l'ordre de aₒ=10^{∗}10⁻⁶/K à 16^{∗}10⁻⁶/K.

3. Système de caméra (10) selon la revendication 1, **caractérisé en ce que** la carte imprimée (20) comprend un support de carte imprimée (40) sur lequel au moins une couche de circuit conductrice (42) est placée, cependant que
• la couche de circuit conductrice (42) est fabriquée substantiellement en un matériau isolant électriquement et est pourvue des circuits prédéfinis de la carte imprimée (20) et
• cependant que le support de carte imprimée (40) est fabriqué en un matériau dont le coefficient de dilatation thermique a_{L} diffère d'au plus 30% du coefficient de dilatation thermique ao du matériau dans lequel le support d'objectif (16) est fabriqué, cependant que
• le matériau dans lequel le support d'objectif (16) est fabriqué ou le matériau dans lequel le support de carte imprimée (40) est fabriqué est en particulier un matériau du groupe de matériaux suivants : le cuivre, les alliages de cuivre comme le laiton et le bronze, l'acier inoxydable, les alliages de magnésium, l'aluminium, les alliages d'aluminium, en particulier les alliages corroyés d'aluminium, le titane, le verre et la céramique vitrifiée.

4. Système de caméra (10) selon la revendication 3, **caractérisé en ce que** le support de carte imprimée (40) et le support d'objectif (16) sont fabriqués dans le même matériau.

5. Système de caméra (10) selon l'une des revendications 1, 3 ou 4, **caractérisé en ce que** l'objectif, le support d'objectif (16) et le support de carte imprimée (20) sont fabriqués chacun en un matériau dont le coefficient de dilatation thermique diffère d'au plus 30% du coefficient de dilatation thermique de la au moins une lentille d'objectif, cependant que le support d'objectif, le support de carte imprimée et le tube existant en option sont fabriqués en particulier en céramique vitrifiée ou en titane.

6. Système de caméra (10) selon la revendication 1, **caractérisé en ce que** le support de carte imprimée est fabriqué en un matériau dont le coefficient de dilatation thermique diffère d'au plus 30% du coefficient de dilatation thermique du capteur d'image/de la puce de caméra (22).

7. Système de caméra (10) selon l'une des revendications précédentes, **caractérisé en ce que** des assemblages collés sont réalisés dans le système de caméra comme assemblages stables thermiquement, le coefficient de dilatation thermique de la colle utilisée différant d'au plus 30% de celui des matériaux dans lesquels les composants à assembler sont fabriqués.

8. Système de caméra selon la revendication 7, **caractérisé en ce que** la colle utilisée présente un coefficient de dilatation thermique de l'ordre de aₖ=22^{∗}10⁶/K à 25^{∗}10⁻⁶/K et de préférence une dureté de l'ordre de 75 à 95 Shore D.

9. Système de caméra (10) selon l'une des revendications précédentes, **caractérisé en ce que** le support de carte imprimée (20) présente, sur son côté tourné vers le capteur d'image (22), au moins une couche de circuit conductrice (42, 42a, 42b, 42c, ...) et, sur son côté opposé au capteur d'image (22), une autre couche de circuit conductrice (42', 42'a, 42'b, 42'c,...), en particulier le nombre de couches de circuit conductrices étant le même des deux côtés si bien qu'il en résulte une structure symétrique des couches.

10. Système de caméra (10) selon l'une des revendications précédentes, **caractérisé en ce que**
• le support d'objectif (16) présente des évidements de fixation (19, 19') pour le logement d'éléments d'assemblage (30, 310') et est pourvu, dans la zone de ces évidements de fixation (19, 19'), de brides de positionnement (15) qui font saillie en direction de la carte imprimée (20) à monter, cependant que de préférence les brides de positionnement (15) prolongent en alignement les évidements de fixation (19, 19') et
• les orifices de fixation (21) dans la carte imprimée (20) sont configurés de telle manière qu'ils reçoivent les brides de positionnement (15).

11. Système de caméra (10) selon la revendication 10, **caractérisé en ce qu'**à l'état monté
• les brides de positionnement (15) du support d'objectif (16) sont logées dans les orifices de fixation (21) de la carte imprimée (20) avec un jeu très faible, par exemple H7/g6 ou
• les brides de positionnement (15) du support d'objectif (16) sont logées dans les orifices de fixation (21) de la carte imprimée (20) dans un ajustement serré ou
• les brides de positionnement (15) du support d'objectif (16) sont collées dans les orifices de fixation (21) de la carte imprimée (20), en particulier avec une colle avec un coefficient de dilatation semblable au coefficient de dilatation de la carte imprimée ou du support d'objectif, à savoir avec un écart de celui-ci d'au plus 30%.

12. Système de caméra (10) selon l'une des revendications 1 à 9, **caractérisé en ce que**
• le support d'objectif (16) et le support de carte imprimée (40) présentent chacun des filets (72, 74, 76, 78) au moyen desquels ils sont vissés l'un à l'autre de telle manière qu'ils sont en prise l'un dans l'autre ou
• le support d'objectif (16) et le support de carte imprimée (40) sont soudés, brasés ou collés l'un à l'autre.

13. Système de caméra (10) selon l'une des revendications 1 à 9, **caractérisé en ce que** le support d'objectif (16) et le support de carte imprimée (40) sont configurés en une pièce.

14. Système de caméra (10) selon l'une des revendications 3 à 13, **caractérisé en ce que** le capteur d'image (22) est positionné flottant sur le support de carte imprimée (40), cependant qu'il est relié de manière fixe au support de carte imprimée (40) au maximum à l'aide de trois points de colle dure (34), de préférence seulement au moins d'un point de colle dure (34) et en option au moyen d'autres points de colle souples (36).
